# EUROPÄISCHE PATENTSCHRIFT

(11) **EP 4 652 469 B1**
(45) Veröffentlichungstag und Bekanntmachung des Hinweises auf die Patenterteilung: **11.03.2026**
(21) Anmeldenummer: 24798765.4
(22) Anmeldetag: 24.10.2024
(51) Int. Cl.: G01R 33/38, G01R 33/3815

(54) **VORRICHTUNG ZUR REGELUNG DES DRUCKS IN EINEM HELIUMTANK EINES NMR-MAGNETEN, MIT ZWEI DRUCKSENSOREN**
DEVICE FOR REGULATING THE PRESSURE IN A HELIUM TANK OF AN NMR MAGNET, COMPRISING TWO PRESSURE SENSORS
DISPOSITIF DE RÉGULATION DE LA PRESSION DANS UN RÉSERVOIR D'HÉLIUM D'UN AIMANT RMN, COMPRENANT DEUX CAPTEURS DE PRESSION

(30) Priorität: 31.10.2023 DE 102023210824
(43) Veröffentlichungstag der Anmeldung: 26.11.2025
(73) Patentinhaber: Bruker Switzerland AG, 8117 Fällanden (CH)
(72) Erfinder: WIKUS, Patrick, 8309 Nürensdorf (CH)
(74) Vertreter: Kohler Schmid Möbus Patentanwälte
(86) Internationale Anmeldenummer: PCT/EP2024/080135
(87) Internationale Veröffentlichungsnummer: WO 2025/093421

(56) Entgegenhaltungen:
- EP-A2- 1 587 114
- US-A1- 2009 261 830

## Beschreibung

Die Erfindung betrifft eine Vorrichtung und ein Verfahren zur Regelung des Drucks in einem Heliumtank eines NMR-Magneten.

Supraleitende Magnete für NMR-Apparaturen, wie NMR-Spektrometer oder NMR-Tomographen, werden oftmals mit flüssigem Helium gekühlt. Ein Kryostat umfasst dabei einen vakuumisolierten Tank, der siedendes flüssiges Helium und den supraleitenden Magneten enthält.

Der Druck in diesem Heliumtank sollte oberhalb des umgebenden Atmosphärendrucks sein, um ein Einsaugen von Luft in den Heliumtank zu verhindern. Eingesaugte Luft kann durch Ausfrierungen von Luftfeuchtigkeit oder anderen Luftbestandteilen wie zum Beispiel Stickstoff zur Bildung von Eis führen, welches Leitungen oder Ventile blockiert, und dadurch die Betriebssicherheit gefährdet.

Der Druck im Heliumtank sollte zudem möglichst konstant sein, da Druckschwankungen im Heliumtank zu Artefakten in den NMR-Messungen führen können, beispielsweise über minimale Verformungen des Heliumtanks und resultierende Bewegungen des supraleitenden Magneten.

In vielen Anwendungsfällen ist der Heliumtank mit einem federbelasteten Überdruckventil versehen, welches mechanisch eine feste Druckdifferenz zwischen dem Heliumtankdruck und dem Atmosphärendruck einrichtet. Entsprechend ist dann der Druck im Heliumtank vom Atmosphärendruck abhängig, und der Heliumtankdruck schwankt dann mit dem wetterabhängigen Atmosphärendruck. Dadurch kann es je nach Wetterverlauf zu erheblichen Artefakten in den NMR-Messungen kommen.

Gemäß der Firmendruckschrift "EAPD II - Electronic Atmospheric Pressure Device II User Manual Version 002" der Bruker Corporation, Billerica, MA, USA, datiert 20. Januar 2020, wird mit einem Drucksensor der Druck im Heliumtank eines NMR-Magneten auf einen vorgegebenen fixen Sollwert eingeregelt. Mit einer elektronischen Steuereinrichtung wird dafür ein Stellventil, durch das Heliumgas aus dem Heliumtank abströmen kann, angesteuert. Als Sollwert wird ein Druck empfohlen, der ca. 15 mbar über dem für den Standort erwarteten, höchsten Atmosphärendruck liegt. Damit kann in den meisten Fällen ein gut konstanter Heliumtankdruck erreicht werden, und das Einsaugen von Luft vermieden werden.

An vielen Standorten kann es jedoch zu stark schwankendem Atmosphärendruck kommen. Beispielsweise kann während der Hurrikan-Saison im Süden und Osten der USA es zu einem wetterbedingten Druckabfall von bis zu ca. 100 mbar kommen. Dann kann die Druckdifferenz zwischen dem Heliumtankdruck und dem Atmosphärendruck so groß werden, dass Sicherheits-Überdruckventile öffnen, um Heliumgas abzulassen, und NMR-Messungen sind nicht mehr unter stabilen Verhältnissen möglich. Bei sehr großen Druckdifferenzen können sogar Berstscheiben des Heliumtanks zerspringen.

Bei vielen Kryostaten ist es zudem erforderlich, gelegentlich flüssiges Helium nachzufüllen. Zum Einführen einer Transferleitung muss der Heliumtank gegen die Atmosphäre geöffnet werden. Wird der Druck im Heliumtank beim Öffnen gegen den Atmosphärendruck plötzlich abgesenkt, kommt es zu einer schlagartigen Freisetzung einer großen Menge kalten Heliumgases, dessen Enthalpie nicht zum Abfangen von Wärme genutzt werden kann, was energetisch ungünstig ist.

Aus der US 3 412 568 A ist ein Druckregulator bekannt geworden, mit dem ein konstanter Druck in einem Kryostaten, der ein Bad eines Kühlmittels aufweist, eingestellt werden kann.

Aus der JP 2015 060973 A ist es bekannt geworden, den Druck in einem Heliumtank eines Kryostaten mittels eines elektrischen Heizers einzustellen.

Aus der DE 10 2005 058 650 B3 ist es bekannt geworden, bei einem MRT-Gerät die Durchgängigkeit eines Turmrohrs eines Kryomagneten mit optischen Mitteln zu überwachen.

Die US 2009/0280989 A1 beschreibt eine Kontrollapparatur und ein zugehöriges Verfahren für die Regelung von Gasdruck und Gasfluss bei einem Kryobehälter für supraleitende Magnetspulen. Mit Sensoren wird der Druck im Behälter und in der Umgebung gemessen. Der Druck im Behälter kann als eine Funktion des Umgebungsdrucks gesteuert werden. Weiterhin wird eine allmähliche Druckreduzierung im Behälter beschrieben.

Die US 2009/0261830 A1 beschreibt einen bildgebenden Magnetresonanz-Scanner. Der Druck in einem Kryobehälter und in der Umgebung werden gemessen und in einen Prozessor eingegeben, der einen Druckregler ansteuert, so dass ein möglichst großer Puffer erhalten wird, bevor Überdruckventile öffnen. Dadurch kann unnötiger Verlust an Kühlmittel vermieden werden. In einem Beispiel wird der Druck im Kryobehälter um 0,1 psi (ca. 689 Pa) über dem Umgebungsdruck gehalten.

Die EP 1 587 114 A2 beschreibt eine supraleitende Magnetapparatur mit einem Spulenbehälter, in welchem ein Kühlmedium, insbesondere flüssiges Helium, vorgehalten wird. Eine Ablassleitung führt aus dem Spulenbehälter in die Umgebung. Mit einem Druckdetektor, welcher nahe dem Leitungsende der Ablassleitung am Spulenbehälter angeordnet ist, kann der Druck im Spulenbehälter gemessen werden. Ein weiterer Druckdetektor ist nahe am Leitungsende nahe dem Auslass zur Umgebung angeordnet. In die Ablassleitung integriert ist ein Schwerkraft-Rückschlagventil. Die Druckdetektoren sind mit der Kontrolleinrichtung verbunden. Die Kontrolleinrichtung steuert eine Kühlvorrichtung zur Kühlung des Mediums und eine Heizeinrichtung für die Ablassleitung.

### Aufgabe der Erfindung

Es ist Aufgabe der Erfindung, eine Vorrichtung und ein Verfahren zur Regelung des Drucks in einem Heliumtank vorzustellen, mit dem die Verfügbarkeit des NMR-Magneten verbessert ist, und eine verbesserte Betriebssicherheit und größere Benutzerfreundlichkeit erreicht werden kann.

### Beschreibung der Erfindung

Diese Aufgabe wird erfindungsgemäß gelöst durch eine Vorrichtung zur Regelung des Drucks in einem Heliumtank eines NMR-Magneten, umfassend
- einen ersten Drucksensor zur Messung eines ersten Drucks im Heliumtank,
- zumindest einen zweiten Drucksensor zur Messung eines zweiten Drucks außerhalb des Heliumtanks,
- ein Stellventil zur Einstellung eines abfließenden Heliumgasstroms aus dem Heliumtank,
- eine elektronische Regeleinrichtung zur Ansteuerung des Stellventils,

wobei die elektronische Regeleinrichtung dazu eingerichtet ist,
   - vom ersten Drucksensor gemessene erste Druckwerte D1 zu erhalten,
   - und eine Stellung des Stellventils (5) in Abhängigkeit von den gemessenen ersten Druckwerten D1 einzustellen, wobei die ersten Druckwerte D1 auf einen vorgegebenen Sollwert SW eingeregelt werden,
   - vom zweiten Drucksensor gemessene zweite Druckwerte D2 zu erhalten,
und wobei die elektronische Regeleinrichtung weiterhin dazu eingerichtet ist, in einem Normalbetrieb für NMR-Messungen
   - den Sollwert SW in Abhängigkeit von den ersten Druckwerten D1 und den zweiten Druckwerten D2 zu ermitteln,
   - nämlich den Sollwert SW für den Druck im Heliumtank stufenweise zu verändern, sobald eine Differenz DIF=D1-D2 zwischen dem gemessenen ersten Druckwert D1 und dem gemessenen zweiten Druckwert D2 vorgegebene Schwellwerte erreicht oder überschreitet,
wobei der Sollwert SW um eine Stufe angehoben wird, wenn die Differenz DIF kleiner oder gleich einem Anhebeschwellwert HSW wird, und der Sollwert SW um eine Stufe abgesenkt wird, wenn die Differenz DIF größer oder gleich einem Absenkschwellwert SSW wird, mit HSW<SSW,
und wobei eine jeweilige Stufe, um die der Sollwert SW verändert wird, sobald die Differenz DIF=D1-D2 zwischen dem gemessenen ersten Druckwert D1 und dem gemessenen zweiten Druckwert D2 die vorgegebenen Schwellwerte erreicht oder überschreitet, im Bereich 5-25 mbar gewählt ist.

Die Erfindung sieht vor, zusätzlich zum ersten Drucksensor, der den ersten Druck im Heliumtank ("Heliumtankdruck") überwacht, einen zweiten Drucksensor vorzusehen, der einen zweiten Druck außerhalb des Heliumtanks überwacht. Der zweite Druck ist typischerweise der Atmosphärendruck oder ein anderer Druck, der vom Atmosphärendruck abhängt, beispielsweise der Druck in einem Heliumrückgewinnungssystem (der meist um eine kleine Druckdifferenz über dem Atmosphärendruck liegt). Der zweite Druck bzw. die zugehörigen vom zweiten Drucksensor gemessenen zweiten Druckwerte D2 werden in die Steuerung des Heliumtankdrucks zumindest über den einzustellenden Sollwert für den Heliumtankdruck (also den Sollwert für die ersten gemessenen Druckwerte D1) einbezogen. Dadurch können auch bei schwankenden Umgebungsbedingungen (erkennbar durch schwankende zweite Druckwerte D2) jeweils geeignete Betriebszustände mit (zumindest zeitweise) stabilem Heliumtankdruck und damit stabilen Messbedingungen bei guter Betriebssicherheit erreicht werden. Weiterhin ist es möglich, den Heliumtankdruck in Hinblick auf den zweiten Druck in einer gewünschten Weise zu überführen, um eine hohe energetische Effizienz bei der Nutzung des flüssigen Heliums im System zu erhalten. Schließlich können gefährliche Betriebszustände (beispielsweise mit hoher Druckdifferenz zwischen D1 und D2) leichter erkannt werden, um über eine Alarmierung eines Benutzers oder auch automatische Gegenmaßnahmen die Betriebssicherheit zu erhöhen.

Die Einstellung des ersten Drucks im Heliumtank erfolgt dadurch, dass für den Druck im Heliumtank in der Regeleinrichtung ein Sollwert SW vorgegeben wird, und durch Betätigung des Stellventils durch die Regeleinrichtung der gemessene erste Druckwert D1 auf den Sollwert SW eingeregelt wird. Um den Druck im Heliumtank abzusenken, kann dann das Stellventil weiter geöffnet werden und/oder in einer geöffneten Stellung gehalten werden, und um den Druck im Heliumtank anzuheben, kann das Stellventil weiter geschlossen werden und/oder in einer geschlossenen Stellung gehalten werden. An sich bekannte Regelverfahren wie P-, I-, PI-, PD- oder PID-Regelung können angewandt werden.

Der Sollwert SW des Drucks im Heliumtank wird erfindungsgemäß im Normalbetrieb in der Regeleinrichtung unter Berücksichtigung des (momentanen) gemessenen zweiten Druckwerts D2 bestimmt, und auch unter Berücksichtigung des (momentanen) gemessenen ersten Druckwerts D1, und unter Berücksichtigung programmierter Vorgaben. Im Rahmen der Einregelung der ersten Druckwerte D1 auf den Sollwert SW wird das Stellventil also in Abhängigkeit sowohl von den ersten Druckwerten D1, als auch in Abhängigkeit von den zweiten Druckwerten D2 und den programmierten Vorgaben eingestellt.

Die elektronische Regeleinrichtung hält (wenn keine Betriebsstörung vorliegt, bei konstantem Sollwert oder nur langsam veränderlichem Sollwert, beispielsweise bei einer Sollwertänderung von 10mbar/h oder weniger, meist 5mbar/h oder weniger) die gemessenen ersten Druckwerte D1 stets nahe beim Sollwert SW, typischerweise mit einer Abweichung von maximal 1 mbar, bevorzugt maximal 0,5 mbar, besonders bevorzugt maximal 0,25 mbar.

Im Normalbetrieb für NMR-Messungen wird der Sollwert SW typischerweise konstant gehalten (zumindest über die Dauer einer NMR-Messung), und entsprechend auch der Druck im Heliumtank durch die Regelung stets nahe bei dem Sollwert gehalten. In bestimmten Betriebssituationen, beispielsweise für das Nachfüllen von flüssigem Helium, können bestimmte Verläufe des Heliumtankdrucks durch Programmierung vorgegeben werden, beispielsweise ein allmähliches Absenken des Heliumtankdrucks auf Atmosphärendruck zur Vorbereitung der Öffnung des Heliumtanks zum Einführen eines Einfüllstutzens, oder ein allmähliches Anheben des Heliumtankdrucks von Atmosphärendruck wieder auf den normalen Betriebsdruck; hierfür wird der vorgegebene Sollwert durch die Regeleinrichtung entsprechend zeitlich geändert. Der Atmosphärendruck (oder ein Druck im Heliumrückgewinnungssystem) kann dabei über den zweiten Drucksensor bestimmt werden.

Mit dem zweiten Drucksensor oder den zweiten Druckwerten kann erkannt werden, wenn eine Änderung des Sollwerts SW für den Heliumtankdruck für einen sicheren Weiterbetrieb notwendig ist, beispielsweise wegen starker Wetteränderungen. Ebenso kann mittels des zweiten Drucksensors oder den zweiten Druckwerten D2 ein gewünschter, energetisch günstiger Verlauf von Druckänderungen und/oder Heliumgasströmen eingerichtet werden.

Man beachte, dass im Rahmen der Erfindung ein interessierender Druck bzw. Druckwert direkt gemessen werden kann, oder auch indirekt über eine Differenz des interessierenden Drucks bzw. Druckwerts zu einem bekannten anderen Druck bzw. Druckwert gemessen werden kann. Beispielsweise können zweite Druckwerte D2 des Atmosphärendrucks über Differenzdruckwerte zwischen der Atmosphäre und dem Heliumtank gemessen werden, wenn der Heliumtankdruck über die ersten Druckwerte D1 bekannt ist.

Die Erfindung sieht vor,
dass die Regeleinrichtung dazu eingerichtet ist, im Normalbetrieb den Sollwert SW für den Druck im Heliumtank stufenweise zu verändern, sobald eine Differenz DIF=D1-D2 zwischen dem gemessenen ersten Druckwert D1 und dem gemessenen zweiten Druckwert D2 vorgegebene Schwellwerte erreicht oder überschreitet,
wobei der Sollwert SW um eine Stufe angehoben wird, wenn die Differenz DIF kleiner oder gleich einem Anhebeschwellwert HSW wird, und der Sollwert SW um eine Stufe abgesenkt wird, wenn die Differenz DIF größer oder gleich einem Absenkschwellwert SSW wird, mit HSW<SSW. Dies verbessert die Verfügbarkeit des NMR-Magneten. Durch die stufenweise Veränderung des Sollwerts kann die Häufigkeit von Änderungen des Sollwerts (und damit eine entsprechende Änderungen des Drucks im Heliumtank) gering gehalten werden, und entsprechend sind dann Unterbrechungen des Messbetriebs nur selten erforderlich.

Durch Wetterveränderungen verändert sich der Atmosphärendruck, ggf. auch vergleichsweise stark.

Wenn der Atmosphärendruck stark ansteigt und dabei über den aktuell eingestellten Sollwert für die ersten Druckwerte bzw. den Heliumtankdruck steigen würde, könnte die Regeleinrichtung den Heliumtankdruck nicht mehr konstant halten, da die Regeleinrichtung darauf angewiesen ist, dass es ein Druckgefällte vom Heliumtank zur Heliumsenke (Atmosphäre oder Heliumrückgewinnungssystem) gibt. Um dann weiterhin einen stabilen Druck in Heliumtank gewährleisten zu können, wird der bisherige Sollwert um eine Stufe auf einen neuen, höheren Sollwert verändert. Während der Druck im Heliumtank auf den neuen Sollwert überführt wird, wäre eine NMR-Messung gestört. Danach kann jedoch wieder ein stabiler Druck im Heliumtank beibehalten werden.

Wenn der Atmosphärendruck zu weit unter den aktuellen Sollwert für den Heliumtankdruck abfällt, würde Helium aus dem Heliumtank über Sicherheitseinrichtungen (Überdruckventile oder gar Berstscheiben) entweichen. In diesem Fall wäre der Druck im Heliumtank nicht mehr stabil, zudem würde wertvolles Helium verloren gehen, und bezüglich Berstscheiben wäre eine Reparatur notwendig. Um dies zu verhindern, wird dann der Sollwert um eine Stufe auf einen neuen, niedrigeren Sollwert verändert. Während der Druck im Heliumtank auf den neuen Sollwert überführt wird, wäre eine NMR-Messung gestört. Danach kann jedoch wieder ein stabiler Druck im Heliumtank beibehalten werden.

Man beachte, dass eine Sollwertänderung von einem bisherigen Sollwert um eine Stufe auf den neuen Sollwert dadurch erfolgen kann, dass mehrere Sollwert-Teiländerungen vorgenommen werden, bis der neue Sollwert erreicht ist. Ebenso kann eine kontinuierliche Sollwertänderung (zB mit einer linearen Sollwertrampe) vorgenommen werden, bis der neue Sollwert erreicht ist. Dadurch kann die Druckänderung pro Zeit im Heliumtank begrenzt werden.

Eine Stufe bezeichnet hier die Differenz zwischen altem Sollwert und neuem Sollwert, wobei auf den Sollwerten jeweils ein Dauerbetrieb/Messbetrieb des Heliumtanks bzw. den NMR-Magneten vorgesehen war bzw. vorgesehen ist. Gemäß der Erfindung wird eine Stufe im Bereich 5-25 mbar gewählt, bevorzugt zwischen 8 und 20 mbar, besonders bevorzugt zwischen 10 und 15 mbar. Man beachte, dass die Stufen, um die jeweils der Sollwert abgesenkt wird, verschieden sein können von den Stufen, um die jeweils der Sollwert angehoben wird. Man beachte weiterhin, dass die Stufen nicht zu klein gewählt und ein Anhebeschwellwert und ein Absenkeschwellwert nicht zu nah beisammen gewählt werden sollten, um die Häufigkeit von Sollwertwechseln zu begrenzen und die Verfügbarkeit der NMR-Messanordnung hoch zu halten. Der neue Schwellwert wird meist um die vorgegebene Stufe relativ zum bisherigen Sollwert geändert; es ist aber auch möglich, den neuen Schwellwert relativ zu einem aktuellen Druckwert (zB dem aktuellen Atmosphärendruck) festzulegen.

Durch den Anhebeschwellwert HSW und den Absenkschwellwert SSW wird effektiv ein Intervall für die Differenz DIF eingerichtet, und der Sollwert SW wird angepasst, wenn die Differenz DIF dieses Intervall verlässt. Solange DIF im Intervall bleibt, wird der Sollwert konstant gelassen.

### Ausführungsformen betreffend Sensoren

Bei einer bevorzugten Ausführungsform der erfindungsgemäßen Vorrichtung ist der zweite Druck ein Druck in der umgebenden Atmosphäre. Der Druck der umgebenden Atmosphäre (auch kurz als Atmosphärendruck bezeichnet) ist für die Betriebssicherheit besonders relevant, insbesondere da die Sicherheitseinrichtungen des Heliumtanks (Überdruckventile und Berstscheiben) auf die Druckdifferenz zwischen Heliumtankdruck und Atmosphärendruck reagieren. Zudem kann der Heliumtankdruck (über einen programmierten Verlauf des Solldrucks) mit guter Genauigkeit auf den Atmosphärendruck abgesenkt werden, wenn der Heliumtank geöffnet werden soll (etwa um einen Heliumtransfer vorzubereiten).

Ebenfalls bevorzugt ist eine Ausführungsform, bei der der zweite Druck ein Druck in einem Heliumrückgewinnungssystem ist. Mit einem Heliumrückgewinnungssystem kann wertvolles, aus dem Heliumtank abgedampftes Helium aufgefangen und beispielsweise für eine Rückverflüssigung gesammelt werden. Der Druck im Heliumrückgewinnungssystem liegt typischerweise leicht (meist bis zu 5 mbar) über dem Atmosphärendruck. Wenn ein Heliumrückgewinnungssystem an die vom Heliumtank abgehende Heliumleitung angeschlossen ist, kann der Druck im Heliumtank nur bis zum Druck im Heliumrückgewinnungssystem abgesenkt werden, was mit dem zweiten Drucksensor dann leicht eingeregelt werden kann.

Besonders bevorzugt ist auch eine Ausführungsform, bei der die Vorrichtung weiterhin umfasst
- einen dritten Drucksensor zur Messung eines dritten Drucks außerhalb des Heliumtanks,
wobei der zweite Druck und der dritte Druck einen Druck in der umgebenden Atmosphäre und einen Druck in einem Heliumrückgewinnungssystem umfassen. Beispielsweise misst der zweite Drucksensor den Druck der umgebenden Atmosphäre, und der dritte Drucksensor misst den Druck im Heliumrückgewinnungssystem. Durch die Messung des zweiten und des dritten Drucks können Störungen im Heliumrückgewinnungssystem (zB ein Ventil, welches aus Versehen geschlossen wurde, oder ein ausgefallener Kompressor) leicht identifiziert werden. Ein typischer Störungszustand (und damit eine typische Alarmsituation) ist ein im Heliumrückgewinnungssystem deutlich höherer Druck (zB mehr als 5 mbar) als der Atmosphärendruck.

Besonders bevorzugt ist eine Ausführungsform, bei der die Vorrichtung weiterhin umfasst
- einen Durchflusssensor zur Messung eines Heliumdurchfluss-Werts des abfließenden Heliumgasstroms aus dem Heliumtank. Der Durchflusssensor wird in Serie mit dem Stellventil (typischerweise in der abgehenden Heliumleitung) geschaltet. Mit dem Durchflusssensor werden erweiterte Überwachungs- und Analysemöglichkeiten eröffnet. Insbesondere kann eine gefährliche Vereisung, die das Abfließen von Heliumgas aus dem Heliumtank blockiert, leicht erkannt werden.

Vorteilhaft ist eine Ausführungsform, bei der die Regeleinrichtung eine Speichereinrichtung oder einen Anschluss für eine Speichereinrichtung umfasst, mit welcher von der Regeleinrichtung erhaltene Sensorwerte aufgezeichnet werden. Durch die Speicherung der Sensordaten werden die Sensordaten für eine spätere Analyse verfügbar. Insbesondere können Artefakte in der NMR-Messung mit Druckschwankungen im Heliumtank und/oder außerhalb des Heliumtanks abgeglichen werden, oder der Heliumverbrauch des Labors bzw. des NMR-Magneten kann analysiert werden. Typischerweise zeichnet die Speichereinrichtung auch erzeugte Steuerungsinformationen auf, beispielsweise den jeweils aktuellen Sollwert für den Heliumtankdruck oder Steuerbefehle an das das Stellventil. Die Speichereinrichtung protokolliert meist den Betrieb eines vorgegebenen zurückliegenden Zeitraums, beispielsweise der letzten 30 Tage oder letzten 180 Tage.

### Ausführungsformen betreffend die Regelung des Tankdrucks

Besonders bevorzugt ist weiterhin eine Ausführungsform, bei der die Regeleinrichtung dazu eingerichtet ist, in einem Sonderbetrieb für das Nachfüllen von flüssigem Helium den Sollwert SW für den Druck im Heliumtank über eine vorgegebene Zeitdauer auf einen Zielwert ZW zu überführen, wobei der Zielwert ZW vom zweiten Druckwert D2 abhängig ist,
insbesondere wobei die Zeitdauer von einem Benutzer ausgewählt werden kann.

Dadurch kann im Rahmen der ständigen Einregelung der ersten Druckwerte D1 auf den zeitlich (langsam) veränderlichen Sollwert der Heliumtankdruck energetisch effizient auf den Zielwert überführt werden.

Diese Funktion ist insbesondere für die Vorbereitung eines Heliumtransfers (Auffüllung von flüssigem Helium im Heliumtank) vorteilhaft. Man beachte, dass Heliumtransfers meist einige Tage im Voraus geplant werden. Für den Heliumtransfer muss der Heliumtank (an einem dafür vorgesehenen Zugang) gegen den Atmosphärendruck geöffnet werden.

Schnelle Druckänderungen im Heliumtank sind energetisch ungünstig. Dies gilt insbesondere für einen schnellen Druckabfall, wie er beim plötzlichen Öffnen eines Heliumtanks, dessen Tankdruck über dem Atmosphärendruck liegt, passiert. Das vor dem Öffnen im Heliumtank befindliche, leicht unter Druck stehende Gas entweicht dann schlagartig. Die Enthalpie des Gases kann dann nicht für Kühlzwecke (etwa an den Tankaufhängungen) genutzt werden. Außerdem entweicht zusätzlich durch eine schlagartige Zunahme der Verdampfungsrate des siedenden Heliums (was auch einen Quench auslösen kann) eine große Menge kalten Gases, dessen Enthalpie ebenfalls nicht genutzt werden kann.

Wenn der Sollwert abhängig vom zweiten Druckwert verändert wird, kann eine langsame und genaue Überführung des Heliumtankdrucks auf den gewünschten, vom zweiten Druck abhängigen Zielwert (meist ist das der Atmosphärendruck selbst) vorgenommen werden, beispielsweise mit Sollwertänderungen von 10 mbar/h oder weniger, oder bevorzugt mit 5 mbar/h oder weniger. Ein Benutzer kann die Zeitdauer der Überführung so planen, dass der gewünschte Zielwert zu einem bestimmten Zeitpunkt erreicht wird, zB wenn der Heliumtransfer planmäßig beginnen soll.

Bei einer bevorzugten Weiterentwicklung dieser Ausführungsform ist vorgesehen, dass der Zielwert ZW dem zweiten Druckwert D2 entspricht mit ZW=D2, oder der Zielwert ZW um einen kleinen Druckaufschlag DA über dem zweiten Druckwert D2 liegt mit ZW=D2+DA und mit DA≤3 mbar. Mit ZW=D2 (wobei der zweite Druck der Atmosphärendruck ist) kann eine Öffnung gegen die Atmosphäre ohne Druckabfall erfolgen. Wenn ZW=D2+DA (wobei der zweite Druck der Atmosphärendruck ist) kann vergleichsweise lange, und auch am Ende der Überführung, noch ein kleiner Überdruck im Heliumtank bewahrt werden, der das Eindringen von Verunreinigungen verhindert.

Vorteilhaft ist eine Weiterbildung, wobei die Regeleinrichtung dazu eingerichtet ist, in dem Sonderbetrieb für das Nachfüllen von flüssigem Helium den Sollwert SW linear mit der Zeit auf den Zielwert ZW zu überführen. Dies ist besonders einfach einzurichten, insbesondere über eine Softwareprogrammierung.

Bei einer alternativen Weiterbildung ist die Regeleinrichtung dazu eingerichtet, in dem Sonderbetrieb für das Nachfüllen von flüssigem Helium den Sollwert SW nicht-linear mit der Zeit zu ändern, wobei ein Heliumdurchfluss durch das Stellventil während der Dauer des Überführens des Sollwerts SW auf den Zielwert ZW näherungsweise konstant gehalten wird.

Dabei kann entweder eine Überführungskurve für den Sollwert als Funktion der Zeit vorab so berechnet/ermittelt werden, dass der näherungsweise konstante Heliumdurchfluss erreicht wird. Alternativ kann ein Durchflussmesser vorgesehen sein, mit dem ein Heliumdurchfluss-Wert des abfließenden Heliumgasstroms aus dem Heliumtank durch das Stellventil gemessen wird, und die Regeleinrichtung verwendet den gemessenen Heliumdurchfluss-Wert als (weitere) Regelgröße.

Druck und Temperatur des siedenden Heliums im Heliumtank sind über die Dampfdruckkurve miteinander verbunden. Die gilt allerdings nur für die Flüssigkeit an der Oberfläche, da Helium eine verhältnismäßig schlechte Wärmeleitfähigkeit hat. Innerhalb des flüssigen Heliums bildet sich bei Druckveränderungen zeitweilig ein Temperaturgradient aus.

Wenn der Druck im Heliumtank schnell angehoben wird, steigt die Temperatur des flüssigen Heliums an der Oberfläche. Das flüssige Helium unterhalb der Oberfläche bleibt kälter, und wärmt sich nur langsam auf die Oberflächentemperatur auf. Während dieser Zeit verdampft weniger flüssiges Helium als die Wärmelast auf den Heliumtank erwarten ließe, da das Helium unterhalb der Oberfläche mit seiner beträchtlichen Wärmekapazität Wärme absorbiert.

Wenn der Druck im Heliumtank schnell abgesenkt wird, sinkt die Temperatur des flüssigen Heliums an der Oberfläche. Das flüssige Helium unterhalb der Oberfläche bleibt wärmer, und kühlt nur langsam auf die Oberflächentemperatur ab. Während dieser Zeit verdampft mehr flüssiges Helium als die Wärmelast auf den Heliumtank erwarten ließe, da dem Helium unterhalb der Oberfläche zum Abkühlen Energie entzogen werden muss. Die Kühlleistung wird von erhöhter Verdampfung bereitgestellt.

Wird der Heliumdurchfluss näherungsweise konstant gehalten, kann die Enthalpie des kalten Gases optimal genutzt werden. Typischerweise wird der Heliumdurchfluss mit einer Genauigkeit um einen Ziel-Heliumdurchfluss von +/-20% (oder noch genauer), bevorzugt +/-15% (oder noch genauer), besonders bevorzugt +/-10% (oder noch genauer), konstant gehalten.

In einer bevorzugten Untervariante dieser Weiterbildung ist die Regeleinrichtung dazu eingerichtet, in dem Sonderbetrieb für das Nachfüllen von flüssigem Helium beim Überführen des Sollwerts SW auf den Zielwert ZW den Sollwert SW am Anfang des Überführens schneller abzusenken als gegen Ende des Überführens. Beim Absenken des Drucks im Heliumtank ist es vorteilhaft, den Druck anfänglich schneller abzusenken (um die anfängliche Verdampfung künstlich zu beschleunigen), und den Druck gegen Ende der Druckabsenkungsphase langsamer zu reduzieren (um die Verdampfungsrate konstant zu halten).

### Ausführungsformen zur Alarmeinrichtung und Alarmsituationen

Besonders vorteilhaft ist eine Ausführungsform, bei der die Vorrichtung weiterhin eine Alarmeinrichtung umfasst, mit der in einer oder mehreren vorgegebenen Alarmsituationen automatisch eine Alarmmeldung ausgelöst wird,
insbesondere wobei die Alarmeinrichtung einen akustischen Signalgeber und/oder einen optischen Signalgeber und/oder einen Funksignalgeber und/oder einen Datensignalgeber umfasst. Durch die Alarmmeldung kann ein Benutzer auf Gefahrenzustände aufmerksam gemacht werden, oder zu einer weitergehenden Überprüfung des Kryostatensystems angehalten werden. Über die Alarmmeldung können manuelle Problembehebungsmaßnahmen oder Sicherungsmaßnahmen veranlasst werden, oder auch Problembehebungsmaßnahmen oder Sicherungsmaßnahmen automatisch ausgelöst und durchgeführt werden.

Bevorzugt ist eine Weiterbildung dieser Ausführungsform, bei der eine Alarmsituation umfasst, dass der Druckwert D1 des Heliumtankdrucks unter den Druckwert D2 des Atmosphärendrucks fällt. Wenn der Druck im Heliumtank unterhalb des Atmosphärendrucks liegt, entsteht eine potenziell gefährliche Situation, da Verunreinigungen durch kleine Lecks in den Heliumtank eingesaugt werden können. Dies trifft besonders auf eingesaugte Luft zu, deren Bestandteile (z.B. Sticktoff) oder deren Feuchtigkeit im Heliumtank ausfrieren und diesen vereisen könnte. Diese Gefahrensituation kann insbesondere bei Systemen mit aktiver Kühlung entstehen, wenn die Kühlung "zu stark" ist, also die aktive Kühlung die Wärmelast auf den Heliumtank überkompensiert.

Vorteilhaft ist auch eine Weiterbildung, bei der eine Alarmsituation umfasst, dass der Druckwert D1 des Heliumtankdrucks einen vorgegebenen Heliumtankdruck-Maximalwert überschreitet,
insbesondere wobei eine erste Alarmsituation zu D1 umfasst, dass der Druckwert D1 des Heliumtankdrucks einen vorgegebenen ersten Heliumtankdruck-Maximalwert EHM überschreitet, eine zweite Alarmsituation zu D1 umfasst, dass der Druckwert D1 des Heliumtankdrucks einen vorgegebenen zweiten Heliumtankdruck-Maximalwert ZHM überschreitet, und ZHM>EHM, und die Alarmmeldungen zur ersten Alarmsituation zu D1 und zur zweiten Alarmsituation zu D1 unterschiedlich sind.

Ein Heliumtankdruck oberhalb eines vorgegebenen Maximaldrucks kann auf verschiedene Arten von Fehlern hindeuten, beispielsweise eine blockierte abgehende Heliumleitung oder ein Fehler, der einen erhöhten Heliumdurchfluss-Wert verursacht (siehe unten). Wenn der Kryostat und die Vorrichtung (einschließlich Stellventil, und ggf. einschließlich Heliumrückgewinnungssystem und ggf. aktiver Kühlung) korrekt funktionieren, deutet ein erhöhter Heliumdruck auf eine Fehlfunktion im supraleitenden NMR-Magneten hin, die zu einer erhöhten Abdampfrate führt, und ggf. sogar einen Quench auslösen kann. Ein Maximalwert kann so gesetzt werden, dass er kurz vor oder alternativ bei Erreichen des Öffnungsdrucks einer Sicherheitseinrichtung (Überdruckventil oder Berstscheibe) erreicht wird. Sind zwei Schwellen (EHM und ZHM) eingerichtet, so sind typischerweise der erste Heliumtankdruck-Maximalwert (EHM) einer Auslösung der Überdruckventile zugeordnet (was zB durch ein versehentlich geschlossenes Ventil am Magnetausgang bewirkt werden kann), und der zweite Heliumtankdruck-Maximalwert (ZHM) ist der Auslösung/Zerstörung der Berstscheiben zugeordnet (typischerweise im Falle eines Quenchs, also einen plötzlichen Verlusts der Supraleitung im NMR-Magneten, "Quenchalarm").

Bevorzugt ist weiterhin eine Weiterbildung, bei der eine Alarmsituation umfasst, dass ein gemessener Heliumdurchfluss-Wert einen vorgegebenen Heliumdurchfluss-Maximalwert überschreitet. Ein erhöhter Heliumdurchfluss deutet meist auf ein Problem im NMR-Magneten hin, beispielsweise eine defekte aktive Kühlung, einen Fehler in der thermischen Isolation, eine Schalteröffnung oder einen gequenchten Joint.

Bevorzugt ist eine Untervariante dieser Weiterbildung, bei der der vorgegebene Heliumdurchfluss-Maximalwert von derzeit oder vor kurzer Zeit angesteuerten Änderungen des Heliumtankdrucks abhängt,
insbesondere wobei der Heliumdurchfluss-Maximalwert während und/oder kurz nach vorgenommenen Absenkungen des Heliumtankdrucks höher ist als bei konstant angesteuertem Heliumtankdruck. Wenn der Druck im Heliumtank abgesenkt wird, dann kommt es zu einem (planmäßigen) kurzzeitigen Anstieg des Heliumdurchflusses über den Normalwert. Dann sollte kein Alarm ausgelöst werden. Durch die bereits oben erwähnte schlechte Wärmeleitfähigkeit flüssigen Heliums ist der Heliumdurchfluss auch für eine gewisse Zeit nach einer Druckreduzierung erhöht. Oben besagte kurze Zeit kann in der Regel zu 3 h oder weniger, meist 2 h oder weniger, angesetzt werden. Eine Änderung des Heliumtankdrucks wird typischerweise dadurch angesteuert, dass der vorgegebene Sollwert SW des Heliumtankdrucks verändert wird.

Vorteilhaft ist weiterhin eine Weiterbildung, bei der eine Alarmsituation umfasst, dass ein gemessener Heliumdurchfluss-Wert einen vorgegebenen Heliumdurchfluss-Minimalwert unterschreitet. Wenn der Heliumdurchfluss zu klein ist, könnte das auf ein Leck in der Leitung zwischen dem Heliumtank und dem Durchflusssensor, oder auf ein Leck am Heliumtank, oder auf eine Vereisung im Heliumtank oder in der vom Heliumtank abgehenden Leitung, die den Durchflusssensor enthält, hindeuten. Möglicherweise ist auch schlicht der NMR-Magnet nicht an die Überwachung (also die erfindungsgemäße Vorrichtung) angeschlossen.

Vorteilhaft ist eine Untervariante dieser Weiterbildung, wobei der vorgegebene Heliumdurchfluss-Minimalwert von derzeit oder vor kurzer Zeit angesteuerten Änderungen des Heliumtankdrucks abhängt,
insbesondere wobei der Heliumdurchfluss-Minimalwert während und/oder kurz nach vorgenommenen Erhöhungen des Heliumtankdrucks niedriger ist als bei konstant angesteuertem Heliumtankdruck. Wenn der Druck im Heliumtank erhöht wird, dann kommt es zu einem kurzzeitigen Absinken des Heliumdurchflusses unter den Normalwert. Dann sollte kein Alarm ausgelöst werden. Durch die bereits oben erwähnte schlechte Wärmeleitfähigkeit flüssigen Heliums ist der Heliumdurchfluss auch für eine gewisse Zeit nach einer Druckerhöhung reduziert. Man beachte, dass der vorgegebene Heliumdurchfluss-Minimalwert während und/oder kurz nach vorgenommenen Erhöhungen des Heliumtankdrucks sogar auf "null" gesetzt werden kann, so dass während dieser Zeit auch ein Heliumdurchfluss-Wert von "null" die Alarmmeldung nicht auslöst. Oben besagte kurze Zeit kann in der Regel zu 3 h oder weniger, meist 2 h oder weniger, angesetzt werden.

Vorteilhat ist eine Weiterbildung, bei der eine Alarmsituation umfasst, dass ein gemessener Heliumdurchfluss-Wert null beträgt und gleichzeitig eine aktuelle Stellung des Stellventils oder eine von der Regeleinrichtung aktuell angesteuerte Stellung des Stellventils nicht geschlossen ist. Ein Absinken des Durchflusses auf null deutet auf eine gefährliche, komplette Vereisung des Kryostaten oder zumindest der abgehenden Heliumleitung hin. Dabei sollte jedoch der Regelzustand berücksichtigt werden: Wenn das Stellventil (planmäßig) komplett geschlossen ist, beispielsweise um eine (gewollte) Erhöhung des Drucks im Heliumtank zu bewirken, sollte kein Alarm ausgelöst werden. Eine Vereisung des Kryostaten (oder auch der abgehenden Heliumleitung) ist eine gefährliche Situation. Die Aufhängerohre, durch die Helium normalerweise abströmt, sind dann blockiert, und das Helium kann nicht mehr aus dem Heliumtank entweichen. Da durch den Wärmeeintrag ständig Helium im Heliumtank verdampft, kommt es zu einem Druckaufbau im Heliumtank, bis dieser birst. Bei NMR-Magneten wird empfohlen, regelmäßig zu prüfen, ob Helium aus dem Auslass des Heliumtanks entweicht. Im Rahmen der Erfindung kann diese Überwachung kontinuierlich und automatisch stattfinden.

Bevorzugt ist weiterhin eine Weiterbildung, bei der eine Alarmsituation umfasst, dass ein gemessener Heliumdurchfluss-Wert null beträgt und gleichzeitig ein Druckwert D2 im Heliumrückgewinnungssystem bis auf den Druckwert D1 im Heliumtank angestiegen ist. Mit dieser Funktion kann unterschieden werden, ob eine Vereisung vorliegt oder lediglich im Heliumrückgewinnungssystem ein geschlossenen Ventil vorliegt. In beiden Fällen sinkt der Heliumdurchfluss auf null; bei einer Vereisung steigt der gemessene Rückgewinnungssystemdruck nicht an, bei einem geschlossenen Ventil steigt er an. Die vorliegende Alarmsituation erkennt also ein geschlossenes Ventil im Heliumrückgewinnungssystem.

Bevorzugt ist weiterhin eine Weiterbildung, bei der eine Alarmsituation umfasst, dass eine Differenz DHA=DHR-DAT eines gemessenen Druckwerts DHR im Heliumrückgewinnungssystem und eines gemessenen Druckwerts DAT in der umgebenden Atmosphäre einen vorgegebenen Schwellwert SWW überschreitet, insbesondere wobei SWW gewählt ist in einem Bereich von 2,5 mbar bis 20 mbar. Meist ist SWW auch größer als 5 mbar gewählt. Diese Funktion erkennt eine Fehlfunktion im Heliumrückgewinnungssystem, beispielsweise einen defekten Kompressor.

Bei einer vorteilhaften Weiterbildung ist vorgesehen, dass zumindest ein Teil der Alarmsituationen eine aktuelle Stellung des Stellventils oder eine von der Regeleinrichtung aktuell angesteuerte Stellung des Stellventils einbezieht. Dadurch können in vielen Fällen Gefahrensituationen oder Fehlfunktionen zielgerichtet erfasst und leichter von gewollten Betriebszuständen unterschieden werden. Beispielsweise ist ein verschwindender gemessener Heliumdurchfluss unkritisch, wenn gelichzeitig planmäßig ein geschlossenes Stellventil angesteuert ist.

### Verfahren zur Druckregelung

In den Rahmen der vorliegenden Erfindung fällt auch ein

Verfahren zur Regelung des Drucks in einem Heliumtank eines NMR-Magneten, wobei mit einem ersten Drucksensor ein erster Druck im Heliumtank (gemessen wird,
wobei mit einem Stellventil ein abfließender Heliumgasstrom aus dem Heliumtank eingestellt wird,
wobei eine elektronische Regeleinrichtung das Stellventil ansteuert,
wobei mit zumindest einem zweiten Drucksensor ein zweiter Druck außerhalb des Heliumtanks gemessen wird,
wobei die elektronische Regeleinrichtung
   - vom ersten Drucksensor gemessene erste Druckwerte D1 erhält,
   - und eine Stellung des Stellventils in Abhängigkeit von den gemessenen ersten Druckwerten D1 einstellt, so dass die ersten Druckwerte D1 auf einen vorgegebenen Sollwert SW eingeregelt werden,
   - und vom zweiten Drucksensor gemessene zweite Druckwerte D2 erhält,
und wobei die elektronische Regeleinrichtung weiterhin in einem Normalbetrieb für NMR-Messungen
   - den Sollwert SW in Abhängigkeit von den gemessenen ersten Druckwerten D1 und zweiten Druckwerten D2 ermittelt,
   - nämlich den Sollwert SW für den Druck im Heliumtank (2) stufenweise verändert, sobald eine Differenz DIF=D1-D2 zwischen dem gemessenen ersten Druckwert D1 und dem gemessenen zweiten Druckwert D2 vorgegebene Schwellwerte erreicht oder überschreitet,
wobei der Sollwert SW um eine Stufe angehoben wird, wenn die Differenz DIF kleiner oder gleich einem Anhebeschwellwert HSW wird, und der Sollwert um eine Stufe abgesenkt wird, wenn die Differenz DIF größer oder gleich einem Absenkschwellwert SSW wird, mit HSW<SSW,
und wobei eine jeweilige Stufe, um die der Sollwert SW verändert wird, sobald die Differenz DIF=D1-D2 zwischen dem gemessenen ersten Druckwert D1 und dem gemessenen zweiten Druckwert D2 die vorgegebenen Schwellwerte erreicht oder überschreitet, im Bereich 5-25 mbar gewählt wird,
insbesondere wobei das Verfahren unter Verwendung einer erfindungsgemäßen, oben angegebenen Vorrichtung durchgeführt wird. Mit dem erfindungsgemäßen Verfahren zur Regelung des Drucks im Heliumtank kann eine verbesserte Betriebssicherheit und eine größere Benutzerfreundlichkeit erreicht werden.

Erfindungsgemäß ist es möglich, einen bisherigen Sollwert für den Heliumtankdruck (mit dem ein im Wesentlichen konstanter Heliumtankdruck eingerichtet wurde) bei Bedarf auf einen geänderten, neuen Sollwert abzuändern (mit dem dann nach einer kurzen Störung wieder ein im Wesentlichen konstanter Heliumtankdruck eingerichtet werden kann). Der Änderungsbedarf kann dabei über die gemessenen zweiten Druckwerte D2 (und die ersten Druckwerte D1) erkannt werden. Der Änderungsbedarf besteht typischerweise darin, dass die zweiten Druckwerte D2 (die den Atmosphärendruck oder einen vom Atmosphärendruck abhängigen anderen Druck, beispielsweise in einem Heliumrückgewinnungssystem repräsentieren) erkennen lassen, dass das für die Regelung erforderliche Druckgefälle zwischen dem Heliumtank und der nachfolgenden Heliumsenke (weitere Installation hinter dem Stellventil) zu klein wird, oder dass ein Druckgefälle zwischen Heliumtank und der umgebenden Atmosphäre so groß wird, dass Sicherungseinrichtungen (Überdruckventile oder Berstscheiben) ausgelöst werden könnten. Diese Sollwertänderung erfolgt erfindungsgemäß gestuft. Zwischen den stufenweisen Änderungen des Sollwerts kann auf diese Weise ein gut stabiler Heliumtankdruck eingerichtet werden, der hochgenaue NMR-Messungen erlaubt. Gleichzeitig kann der der NMR-Magnet bzw. dessen Kryostat einschließlich des Heliumtanks sicher betrieben werden, insbesondere ohne Regelungsausfall oder Einsaugen von Luft und ohne Auslösen von Sicherungseinrichtungen wegen zu großer Druckdifferenzen.

Ebenso ist es möglich, den Heliumtankdruck in definierter Weise relativ zum zweiten Druck durch eine entsprechend programmierte Sollwertänderung langsam auf einen Zielwert zu überführen, um die Kühlwirkung des aus dem Heliumtank entweichenden Gases besonders effizient zu nutzen.

Schließlich können auch einige Gefahrensituationen mit dem zweiten Drucksensor erkannt werden.

Bevorzugt ist zudem eine Variante, die vorsieht,
dass die Regeleinrichtung in einem Sonderbetrieb für das Nachfüllen von flüssigem Helium den Sollwert SW für den Druck im Heliumtank über eine vorgegebene Zeitdauer auf einen Zielwert ZW überführt, wobei der Zielwert ZW vom zweiten Druckwert D2 abhängig ist,
insbesondere wobei die Zeitdauer von einem Benutzer ausgewählt werden kann, insbesondere wobei das Verfahren unter Verwendung einer Vorrichtung nach Anspruch 9 durchgeführt wird. Durch den von den zweiten Druckwerten D2 abhängigen Zielwert ZW kann ein definierter Endzustand mit gewünschten Eigenschaften im Verhältnis zum zweiten Druck zuverlässig erreicht werden, insbesondere so dass anschließende Maßnahmen wie eine Öffnung des Heliumtanks gegen die Atmosphäre zuverlässig unter den gewünschten Bedingungen (gewünschten Druckverhältnissen) definiert verlaufen können. Insbesondere kann beim Öffnen des Heliumtanks gegen die Atmosphäre, etwa vor einem Heliumtansfer, ein starker plötzlicher Druckabfall vermieden werden. Zudem kann ein gewünschter, energetisch günstiger Verlauf des Heliumdrucks über die programmierte Überführung des Sollwerts eingerichtet werden, wodurch eine hohe energetische Effizienz ermöglicht wird; die Überführung (Änderung des Sollwerts) erfolgt typischerweise stetig und monoton, bevorzugt streng monoton. Die Überführung erfolgt dabei in einer Weise, dass die ersten Druckwerte D1 stets nahe beim Sollwert SW bleiben (was durch eine geeignete Regelgeschwindigkeit unter Berücksichtigung des Zusammenspiels von Regeleinrichtung und NMR-Magnet erreicht werden kann, siehe vorne).

Bevorzugt ist eine Weiterentwicklung dieser Variante, bei der die Regeleinrichtung in dem Sonderbetrieb für das Nachfüllen von flüssigem Helium den Sollwert SW nicht-linear mit der Zeit ändert, wobei ein Heliumdurchfluss durch das Stellventil während der Dauer des Überführens des Sollwerts SW auf den Zielwert ZW näherungsweise konstant gehalten wird,
insbesondere wobei das Verfahren unter Verwendung einer Vorrichtung nach Anspruch 10 durchgeführt wird. Durch die nicht-lineare Änderung des Sollwerts können bei angesteuerten Druckänderungen im Heliumtank aufkommende Temperaturgradienten im flüssigen Helium berücksichtigt werden, die sich auf die Abdampfrate von Heliumgas auswirken und sich erst im Laufe einer gewissen Zeit abbauen. Über die nicht-lineare Änderung des Sollwerts bzw. angesteuerte Druckänderung im Heliumtank kann dann die näherungsweise konstante Abdampfrate von Heliumgas (entsprechend einem konstanten Heliumgasfluss) eingestellt werden, die energetisch besonders günstig ist.

Bevorzugt ist zudem eine Variante des erfindungsgemäßen Verfahrens, die vorsieht,
dass mit einer Alarmeinrichtung in einer oder mehreren vorgegebenen Alarmsituationen automatisch eine Alarmmeldung ausgelöst wird,
insbesondere wobei die Alarmeinrichtung einen akustischen Signalgeber und/oder einen optischen Signalgeber und/oder einen Funksignalgeber und/oder einen Datensignalgeber umfasst,
und dass eine Alarmsituation umfasst, dass ein gemessener Heliumdurchfluss-Wert des abfließenden Heliumgasstrom aus dem Heliumtank durch das Stellventil null beträgt und gleichzeitig eine aktuelle Stellung des Stellventils oder eine von der Regeleinrichtung aktuell angesteuerte Stellung des Stellventils nicht geschlossen ist,
insbesondere wobei das Verfahren unter Verwendung einer Vorrichtung nach Anspruch 19 durchgeführt wird. Ein Heliumdurchfluss-Wert von null, trotz geöffnetem Stellventil, deutet auf eine gefährliche Vereisung des Heliumtanks oder der vom Heliumtank abgehenden Heliumleitung hin, die das Stellventil enthält; dieser Zustand wird mit der vorgesehenen Funktion erkannt und gemeldet, insbesondere um Gegenmaßnahmen oder Sicherungsmaßnahmen einzuleiten. Wenn die Regeleinrichtung den Druck im Heliumtank (planmäßig) anheben will, beispielsweise weil der Umgebungsdruck wetterbedingt stark angestiegen ist, so schließt die Regeleinrichtung (planmäßig) das Stellventil, und der Heliumdurchfluss-Wert fällt (planmäßig) für einige Zeit auf null, was dann keinen Alarm auslöst.

### Kryostatenanordnungen und NMR-Messanordnungen

In den Rahmen der vorliegenden Erfindung fällt weiterhin eine Kryostatenanordnung, umfassend
- einen vakuumisolierten Heliumtank, und
- eine erfindungsgemäße, oben beschriebene Vorrichtung,

wobei der erste Drucksensor mit dem Heliumtank verbunden ist, und der zweite Drucksensor mit einem Ort außerhalb des Heliumtanks verbunden ist, insbesondere wobei der zweite Drucksensor mit der umgebenden Atmosphäre oder mit einem Heliumrückgewinnungssystem verbunden ist,
und wobei das Stellventil in einer vom Heliumtank abgehenden Heliumleitung angeordnet ist. Mit der Kryostatenanordnung ist kann eine Regelung des Drucks im Heliumtank mit verbesserter Betriebssicherheit und hoher Benutzerfreundlichkeit erfolgen.

Bevorzugt ist eine Ausführungsform der erfindungsgemäßen Kryostatenanordnung, bei der die Kryostatenanordnung weiterhin ein Heliumrückgewinnungssystem umfasst, welches an der abgehenden Heliumleitung angeschlossen ist. Dadurch kann das wertvolle abdampfende Heliumgas aufgefangen und gespeichert werden, und insbesondere nach einer Rückverflüssigung für eine weitere Kühlung des NMR-Magneten wiederverwendet werden.

Weiterhin fällt auch in den Rahmen der vorliegenden Erfindung eine NMR-Messanordnung, umfassend
- eine erfindungsgemäße, oben beschriebene Kryostatenanordnung,
- einen supraleitenden NMR-Magneten im Heliumtank der Kryostatenanordnung,
- einen NMR-Probenkopf, der in eine Raumtemperaturbohrung des vakuumisolierten Heliumtanks einragt, und
- eine NMR-Spektrometer-Steuereinrichtung, zur Ansteuerung von NMR-Messungen mit dem NMR-Probenkopf. Mit der NMR-Messanordnung können bei hoher Betriebssicherheit und großer Benutzerfreundlichkeit NMR-Messungen mit hoher Auflösung erfolgen, insbesondere unter Vermeidung von Artefakten durch Druckschwankungen im Heliumtank.

Ebenso fällt in den Rahmen der vorliegenden Erfindung die Verwendung einer erfindungsgemäßen, oben beschriebenen NMR-Messanordnung zur Durchführung von NMR-Messungen,
wobei die elektronische Regeleinrichtung einen Status der Regelung des Heliumtankdrucks an die NMR-Spektrometer-Steuereinrichtung kommuniziert,
und wobei während Zeiten von Druckinstabilität im Heliumtank die NMR-Spektrometer-Steuereinrichtung die NMR-Messungen pausiert. Durch dieses Vorgehen werden Artefakte in den NMR-Messungen vermieden. Typische Zeiten einer Druckinstabilität, in denen die NMR-Messungen pausieren, sind Zeiten, während denen die Regeleinrichtung eine Änderung des Sollwerts ansteuert, und sich der Druck im Heliumtank entsprechend ändert. Zudem können auch in Zeiten im Anschluss an eine Änderung des Sollwerts die NMR-Messungen pausiert werden, während derer sich noch Temperaturgradienten im flüssigen Helium ausgleichen (also der Heliumtank und damit auch der Druck im Heliumtank sich noch nicht im thermischen Gleichgewicht befindet); letztere Zeiten liegen meist im Bereich von bis zu drei Stunden, und können oft an einem noch nicht konstanten Heliumdurchfluss (oder einem entsprechenden Verlauf der angesteuerten oder tatsächlichen Stellung des Stellventils) erkannt werden. Während sich der Heliumdurchfluss noch ändert, kann sich noch die Temperaturverteilung im Kryostaten ändern, was wiederum Längenänderungen beispielsweise an Aufhängungen des Heliumtanks bewirken kann; solche Längenänderungen können Artefakte in NMR-Messungen verursachen.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

- Fig. 1: illustriert schematisch eine erste Ausführungsform einer erfindungsgemäßen Vorrichtung zur Regelung des Drucks in einem Heliumtank, wobei mit einem zweiten Drucksensor ein zweiter Druck in der umgebenden Atmosphäre bestimmt wird;
- Fig. 2: illustriert schematisch eine zweite Ausführungsform einer erfindungsgemäßen Vorrichtung, wobei mit einem zweiten Drucksensor ein zweiter Druck in der umgebenden Atmosphäre bestimmt wird, und mit einem Durchflusssensor ein abfließender Heliumgasstrom gemessen wird;
- Fig. 3: illustriert schematisch eine dritte Ausführungsform einer erfindungsgemäßen Vorrichtung, wobei mit einem zweiten Drucksensor ein zweiter Druck in einem Heliumrückgewinnungssystem bestimmt wird;
- Fig. 4: illustriert schematisch eine vierte Ausführungsform einer erfindungsgemäßen Vorrichtung, wobei mit einem zweiten Drucksensor ein zweiter Druck in einer umgebenden Atmosphäre und mit einem dritten Drucksensor ein dritter Druck in einem Heliumrückgewinnungssystem bestimmt wird;
- Fig. 5: illustriert schematisch eine fünfte Ausführungsform einer erfindungsgemäßen Vorrichtung, ähnlich der Ausführungsform von Fig. 4, wobei ein zusätzlicher Leitungsstrang für einen Abfluss von Helium bei einem Stromausfall vorgesehen ist;
- Fig. 6: illustriert schematisch eine Ausführungsform einer erfindungsgemäßen NMR-Messanordnung, umfassend eine Ausführungsform einer erfindungsgemäßen Kryostatenanordnung, wobei die Kryostatenanordnung eine erfindungsgemäße Vorrichtung umfasst, die hier gemäß der Ausführungsform von Fig. 5 ausgebildet ist;
- Fig. 7: illustriert in einem schematischen Diagramm eine erste Variante eines erfindungsgemäßen Verfahrens zur Regelung des Drucks in einem Heliumtank, wobei in einem Sonderbetrieb der Sollwert für den Druck im Heliumtank entlang einer linearen Rampe auf einen Zielwert abgesenkt wird, der dem gemessenen Atmosphärendruck entspricht;
- Fig. 8: illustriert in einem schematischen Diagramm eine zweite Variante eines erfindungsgemäßen Verfahrens zur Regelung des Drucks in einem Heliumtank, wobei in einem Sonderbetrieb der Sollwert für den Druck im Heliumtank entlang einer nicht-linearen Rampe auf einen Zielwert abgesenkt wird, der dem gemessenen Atmosphärendruck entspricht;
- Fig. 9: illustriert in einem schematischen Diagramm eine dritte Variante eines Verfahrens zur Regelung des Drucks in einem Heliumtank, wobei in einem Normalbetrieb der Sollwert für den Druck im Heliumtank stufenweise verändert wird;
- Fig. 10: illustriert schematisch einen Prüfungsablauf zur Feststellung einer Vereisung des Kryostaten und eine entsprechende Ausgabe einer Alarmmeldung, wobei der Prüfungsablauf in einem erfindungsgemäßen Verfahren zur Regelung des Drucks in einem Heliumtank angewandt werden kann.

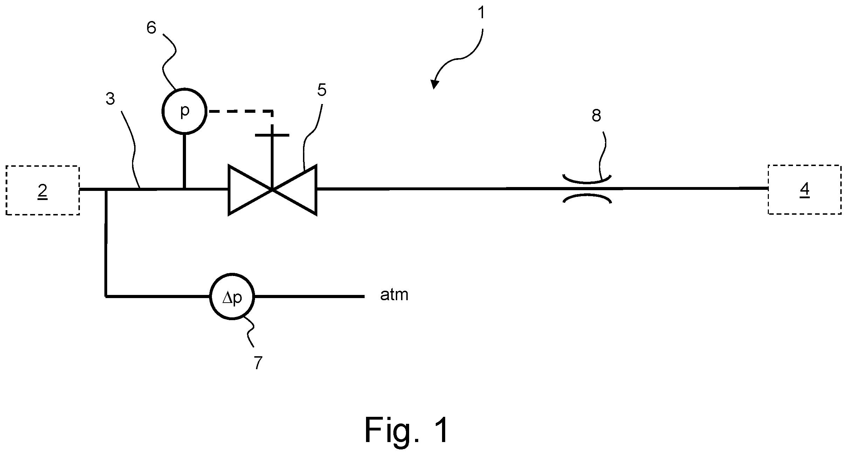

Die **Figur 1** zeigt schematisch eine erste Ausführungsform einer erfindungsgemäßen Vorrichtung 1 zur Regelung des Drucks in einem Heliumtank 2 eines NMR-Magneten.

Eine von dem Heliumtank 2 abgehende Heliumleitung 3 verbindet den Heliumtank 2 hier mit einem Heliumrückgewinnungssystem 4. In die Heliumleitung 3 ist ein automatisiert betätigbares Stellventil 5 integriert. Das Stellventil 5 verfügt für seine Betätigung beispielsweise über einen Elektromotor (nicht näher dargestellt). In der Heliumleitung 3 vor dem Stellventil 5 ist zudem ein erster Drucksensor 6 angeordnet, mit dem der Druck im Heliumtank 2 gemessen werden kann.

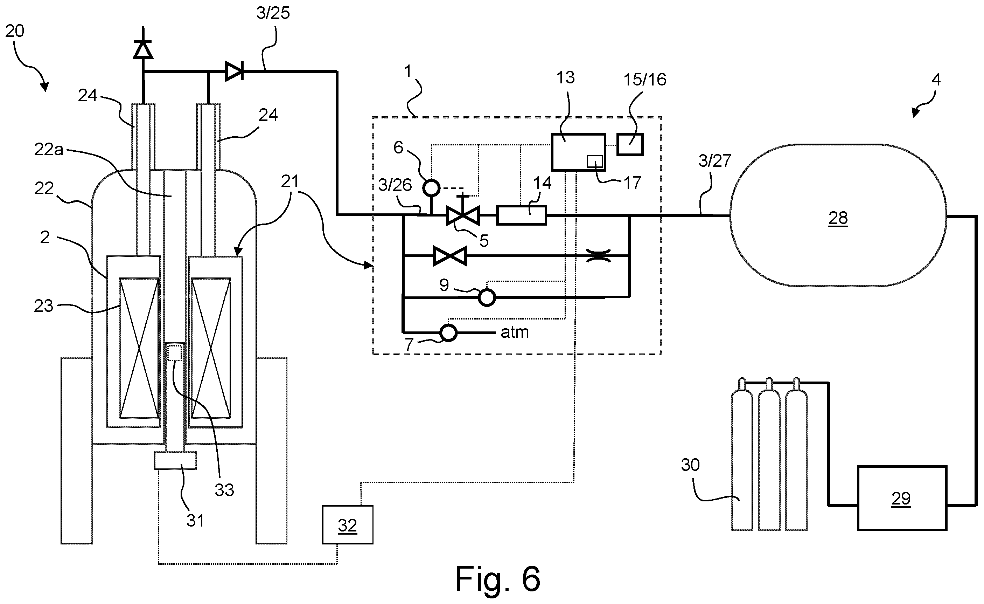

Vom ersten Drucksensor 6 ermittelte erste Druckwerte D1 werden von einer elektronischen Regeleinrichtung (hier nicht näher dargestellt, vgl. aber Fig. 6 hierzu) ausgelesen und mit einem vorgegebenen Sollwert SW für den Heliumtankdruck verglichen. Die Regeleinrichtung steuert das Stellventil 5 so an, dass der Heliumtankdruck bzw. die gemessenen ersten Druckwerte D1 auf den Sollwert SW eingeregelt werden. Wenn die Einregelung korrekt arbeitet (also keine Störung/Defekt vorliegt), bleiben die ersten Druckwerte D1 stets nahe beim Sollwert SW, typischerweise mit einer Abweichung von 1 mbar oder weniger.

Weiterhin ist ein zweiter Drucksensor 7 vorgesehen, der hier eine Druckdifferenz zwischen dem Druck im Heliumtank und dem Druck der umgebenden Atmosphäre atm misst. Dadurch (und mit Kenntnis der ersten Druckwerte D1) wird indirekt ein zweiter Druck außerhalb des Heliumtanks 2 gemessen, hier der Atmosphärendruck. Die entsprechenden zweiten Druckwerte D2 des Atmosphärendrucks werden von der Regeleinrichtung ausgewertet, wobei von der Regeleinrichtung mittels der zweiten Druckwerte D2 der vorgegebene Sollwert SW ermittelt wird, welcher für die Einregelung des Stellventils 5 verwendet wird.

Man beachte, dass der Atmosphärendruck vom Wetter abhängt, und sich mit der Zeit ändert, bei einsprechenden Wetterlagen ggf. auch stark ändert.

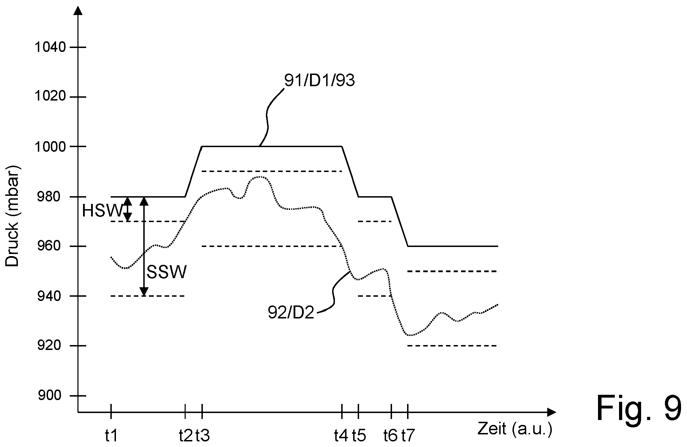

Im Normalbetrieb wird der Sollwert SW konstant gehalten, solange sich aus den gemessenen zweiten Druckwerten D2 (und ggf. auch den ersten Druckwerten D1) keine Notwendigkeit für die Änderung des Sollwerts SW ergibt; die Kriterien, wann eine Änderung des Sollwerts SW notwendig ist und wie diese dann zu erfolgen hat, werden in der Programmierung der Regeleinrichtung festgelegt. Im Rahmen der Erfindung wird der Sollwert SW konstant gehalten, solange sich die zweiten Druckwerte D2 in einem vorgegebenen Intervall bezüglich des bisherigen Sollwerts SW (bzw. bezüglich des jeweiligen ersten Druckwerts D1) befinden; wenn die zweiten Druckwerte D2 das vorgegebene Intervall verlassen, erfolgt eine stufenweise Änderung des Sollwerts SW (mehr dazu bei Fig. 9).

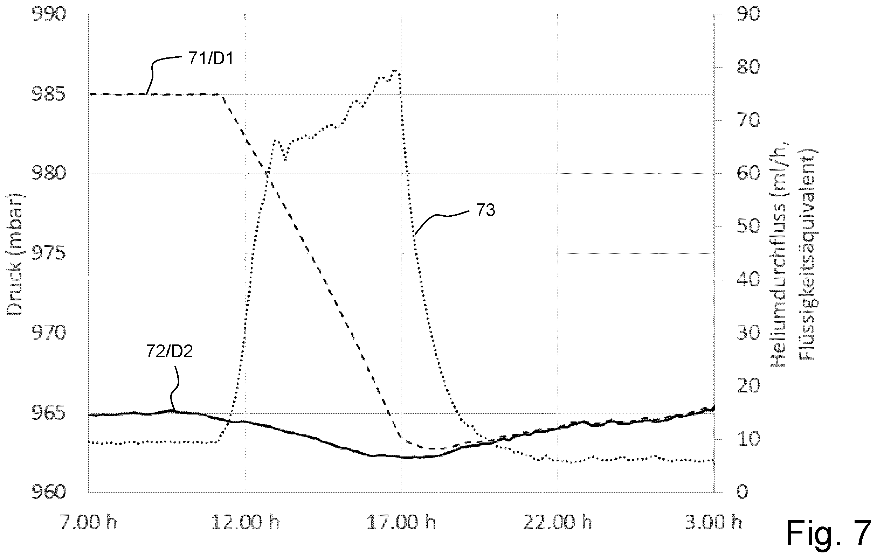

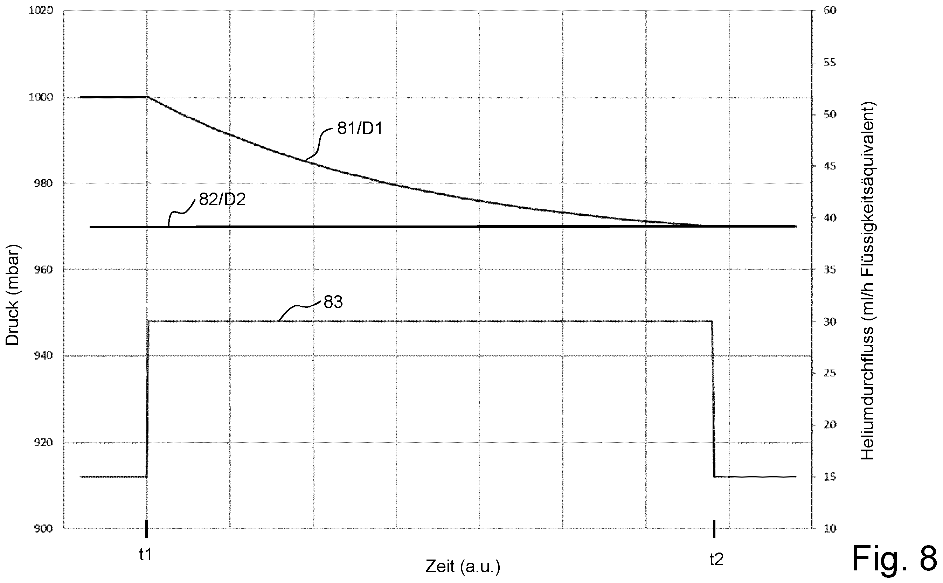

Zudem ist es möglich, für einen Sonderbetrieb in der Regeleinrichtung eine allmähliche Überführung des Heliumtankdrucks bzw. des Sollwerts SW auf einen Zielwert ZW zu programmieren, wobei der Zielwert ZW mittels der zweiten Druckwerte D2 ermittelt wird. Beispielsweise kann als Zielwert der jeweilige zweite Druckwert D2, hier der Atmosphärendruck, gewählt sein, um eine Öffnung des Heliumtanks gegen die Atmosphäre vorzubereiten, um flüssiges Helium im Heliumtank 2 nachzufüllen (mehr hierzu bei Fig. 7 und Fig. 8).

In der Ausführungsform von Fig. 1 ist das Stellventil 5 so ausgelegt, dass im Falle eines Stromausfalls das Stellventil 5 eine voll geöffnete Stellung einnimmt. Dadurch ist sichergestellt, dass sich im Heliumtank 2 kein gefährlicher Druck aufbauen kann. Der bei voll geöffnetem Stellventil 5 abfließende Heliumgasstrom wird durch eine Drossel 8 in der Heliumleitung 3 begrenzt.

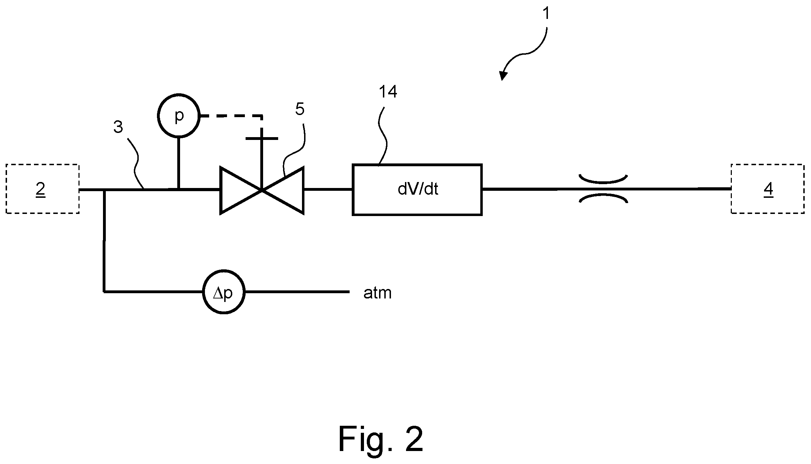

Die **Figur 2** zeigt schematisch eine zweite Ausführungsform einer erfindungsgemäßen Vorrichtung 1 zur Regelung des Drucks in einem Heliumtank 2. Die Ausführungsform von Fig. 2 entspricht weitgehend der Ausführungsform von Fig. 1, so dass nur die wesentlichen Unterschiede erläutert werden.

Bei der Vorrichtung 1 von Fig. 2 enthält die Heliumleitung 3 weiterhin einen Durchflusssensor 14, mit dem der momentan durch die Heliumleitung 3 bzw. das Stellventil 5 durchfließende Heliumgasstrom gemessen wird. Entsprechende Heliumdurchfluss-Werte werden von der Regeleinrichtung ausgelesen. Der Durchflusssensor 14 ist hier in Fließrichtung hinter dem Stellventil 5 in der Heliumleitung 3 angeordnet.

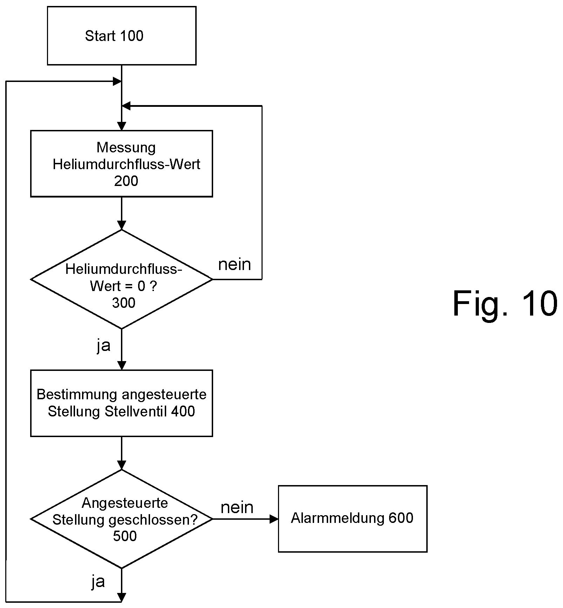

Die Regeleinrichtung kann mit den Heliumdurchfluss-Werten eine Kontrolle des korrekten Betriebszustands der Vorrichtung 1 bzw. des gesamten zugehörigen Kryostaten (vgl. Fig. 6 hierzu) vornehmen. Dabei werden typischerweise von der Regeleinrichtung diverse Alarmsituationen überprüft. Insbesondere kann überprüft werden, ob eine gefährliche Vereisung des Kryostaten vorliegt (siehe hierzu auch Fig. 10).

Der Durchflusssensor 14 bestimmt typischerweise das momentane, je Zeiteinheit durchfließende Volumen an Heliumgas (dV/dt); hierfür kann insbesondere ein Turbinenrad-Durchflussmesser eingesetzt werden. Es ist aber auch möglich, mit einem Durchflusssensor die momentane, je Zeiteinheit durchfließende Masse an Heliumgas zu bestimmen (dm/dt), beispielsweise mit einem Coriolis-Massendurchflussmesser oder einem thermischen Massendurchflussmesser.

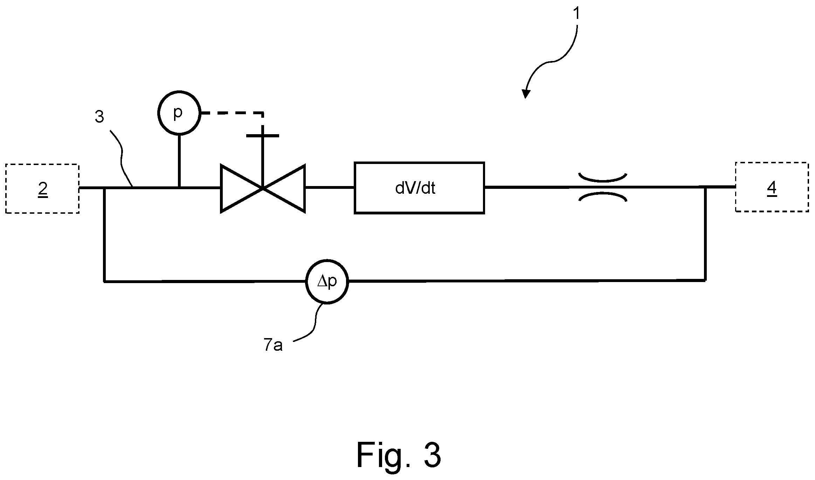

Die **Figur 3** zeigt eine dritte Ausführungsform einer erfindungsgemäßen Vorrichtung, die weitgehend der Ausführungsform von Fig. 2 entspricht. Es werden daher nur die wesentlichen Unterschiede erläutert.

In der Ausführungsform von Fig. 3 ist ein zweiter Drucksensor 7a vorgesehen, der eine Druckdifferenz zwischen dem Druck im Heliumtank 2 und dem Druck der im Heliumrückgewinnungssystem 4 (hier an dessen Eingang) misst. Dadurch (und mit Kenntnis der ersten Druckwerte D1) wird indirekt ein zweiter Druck außerhalb des Heliumtanks 2 gemessen, hier der Druck im Heliumrückgewinnungssystem 4. Die entsprechenden zweiten Druckwerte D2 des Drucks im Heliumrückgewinnungssystem 4 werden von der Regeleinrichtung ausgewertet, wobei mittels der zweiten Druckwerte D2 der vorgegebene Sollwert SW ermittelt wird, welcher für die Einregelung des Stellventils 5 verwendet wird.

Man beachte, dass der Druck im Heliumrückgewinnungssystem 4 typischerweise geringfügig über dem Atmosphärendruck liegt, meist um bis zu 5 mbar.

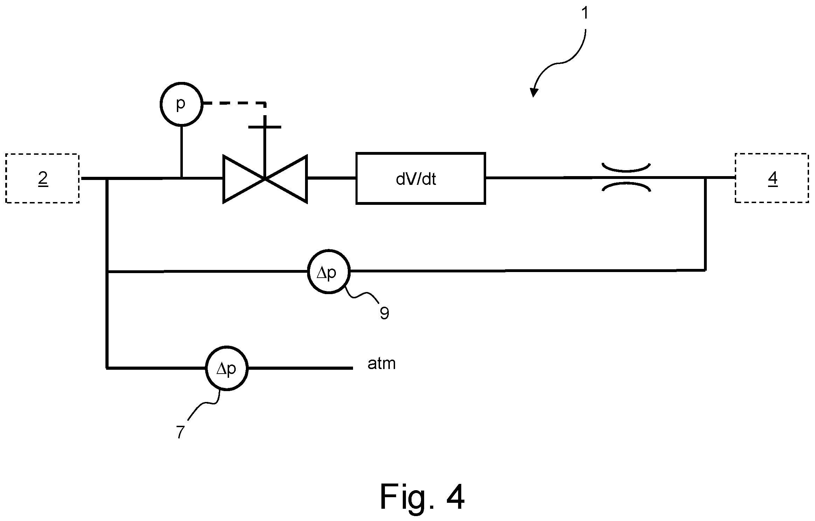

Die **Figur 4** zeigt eine vierte Ausführungsform einer erfindungsgemäßen Vorrichtung, die weitgehend der Ausführungsform von Fig. 2 entspricht. Es werden daher nur die wesentlichen Unterschiede erläutert.

In dieser Ausführungsform ist zum einen ein zweiter Drucksensor 7 vorgesehen, der hier den Differenzdruck zwischen dem Heliumtank 2 und der umgebenden Atmosphäre atm misst, wodurch indirekt (mit den ersten Druckwerten D1) der Atmosphärendruck gemessen wird. Zugehörige zweite Druckwerte D2 (auch bezeichnet mit DAT) des gemessenen Atmosphärendrucks werden an die Regeleinrichtung übergeben. Zum anderen ist hier ein dritter Drucksensor 9 vorgesehen, der hier die Druckdifferenz zwischen dem Heliumtank 2 und dem Heliumrückgewinnungssystem 4 (hier an dessen Eingang) misst, wodurch indirekt (mit den ersten Druckwerten D1) der Druck im Heliumrückgewinnungssystem 4 gemessen wird. Zugehörige dritte Druckwerte D3 (auch bezeichnet als DHR) des Drucks im Heliumrückgewinnungssystem 4 werden ebenfalls an die Regeleinrichtung übergeben.

Mit den zweiten Druckwerten D2 kann der vorgegebene Sollwert bestimmt werden. Mit den ersten Druckwerten D1, den zweiten Druckwerten D2, den dritten Druckwerten D3 und den Heliumdurchfluss-Werten werden diverse Alarmzustände überprüft, mit denen mittels der elektronischen Regeleinrichtung der ordnungsgemäße Betrieb der Vorrichtung 1 bzw. des gesamten Kryostaten überwacht werden kann. Insbesondere können durch einen Vergleich der zweiten Druckwerte D2 (=DAT) und dritten Druckwerte D3 (=DHR) Fehlfunktionen im Heliumrückgewinnungssystem 4 erkannt werden. Beispielsweise führt ein ausgefallener Kompressor im Heliumrückgewinnungssystem 4 dazu, dass der Druck DHR den Druck DAT um mehr als einen vorgegebenen Schwellwert SWW übertrifft, wobei SWW beispielsweise zu 10 mbar gewählt ist.

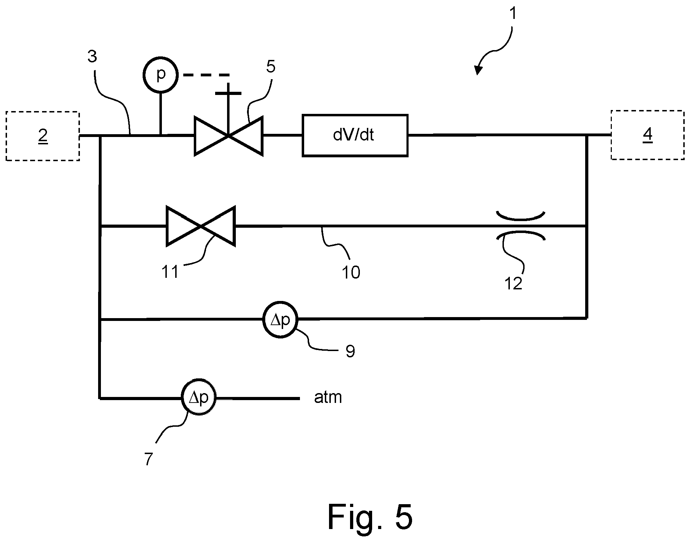

Die **Figur 5** zeigt eine fünfte Ausführungsform einer erfindungsgemäßen Vorrichtung, die weitgehend der Ausführungsform von Fig. 4 entspricht. Es werden daher nur die wesentlichen Unterschiede erläutert.

In der Ausführungsform von Fig. 5 ist ein zusätzlicher Leitungsstrang 10 vorgesehen, der parallel zur Heliumleitung 3 vom Heliumtank 2 zum Heliumrückgewinnungssystem 4 führt. Der zusätzliche Leitungsstrang 10 enthält ein Absperrventil 11 und eine Drossel 12. Das Absperrventil 11 wird im Normalbetrieb durch einen elektrischen Betätiger (nicht dargestellt) geschlossen gehalten, so dass der zusätzliche Leitungsstrang 10 blockiert ist, und Heliumgasfluss nur durch die Heliumleitung 3 erfolgen kann.

Das Stellventil 5 in der Heliumleitung 3 ist hier so ausgebildet, dass es bei Ausfall der Stromversorgung eine geschlossene Stellung einnimmt; die Heliumleitung 3 ist dann also blockiert. Im Gegensatz dazu ist das Absperrventil 11 so ausgebildet, dass es bei Ausfall der Stromversorgung eine geöffnete Stellung einnimmt (der elektrische Betätiger kann bei Stromausfall das Absperrventil 11 nicht mehr geschlossen halten, stattdessen geht das Absperrventil 11 dann auf, typischerweise durch Federkraft). Dadurch kann bei Stromausfall Heliumgas durch den zusätzlichen Leitungsstrang 10 aus dem Heliumtank 2 zum Heliumrückgewinnungssystem 4 abströmen; der Heliumgasstrom wird dabei durch die Drossel 12 im zusätzlichen Leitungsstrang 10 begrenzt. Ein gefährlicher Druckaufbau im Heliumtank 2 bei Stromausfall wird so vermieden.

Die **Figur 6** illustriert beispielhaft eine Ausführungsform einer erfindungsgemäßen NMR-Messvorrichtung 20, in der eine beispielhafte Ausführungsform einer erfindungsgemäßen Kryostatenanordnung 21 enthalten ist.

Die Kryostatenanordnung 21 umfasst zum einen einen evakuierten Behälter 22 (auch Vakuumtank genannt), in welchem ein Heliumtank 2 angeordnet ist; der Heliumtank 2 ist also vakuumisoliert. Der Heliumtank 2 ist teilweise mit flüssigem Helium gefüllt, und teilweise mit gasförmigem Helium gefüllt (Helium nicht näher dargestellt), und enthält zudem einen supraleitenden NMR-Magneten 23, der durch das flüssige Helium gekühlt wird.

Zum anderen umfasst die Kryostatenanordnung 21 eine Vorrichtung 1 zur Regelung des Drucks im Heliumtank 2, die im Wesentlichen wie in Fig. 5 dargestellt ausgebildet ist. Hier auch dargestellt ist die elektronische Regeleinrichtung 13, die Messwerte von den Drucksensoren 6, 7, 9 und vom Durchflussmesser 14 erhält, und auch die Stellung des Stellventil 5 ansteuern und auslesen kann. Die Regeleinrichtung umfasst zudem eine Speichereinrichtung 17, in der erhaltene Messdaten und erzeugte Steuerdaten hier der letzten 30 Tage abgespeichert werden. Die elektronische Regeleinrichtung 13 ist zudem mit einer Alarmeinrichtung 15 verbunden, die einen hier akustischen und optischen Signalgeber 16 umfasst, mit dem erkannte Alarmsituationen bekannt gemacht werden.

Der Heliumtank 2 ist über Halsrohre 24 und einen vorderen Abschnitt 25 der abgehenden Heliumleitung 3 mit der Vorrichtung 1, genauer mit einem mittleren Abschnitt 26 der Heliumleitung 3, welcher in der Vorrichtung 1 verläuft, verbunden. Entsprechend kann der erste Drucksensor 6 den Druck im Heliumtank 2 messen.

Die Kryostatenanordnung 21 umfasst hier weiterhin auch das Heliumrückgewinnungssystem 4, welches an einen hinteren Abschnitt 27 der Heliumleitung 3 angeschlossen ist. Das Heliumrückgewinnungssystem 4 umfasst hier einen Ballonspeicher 28, in dem Heliumgas zunächst aufgefangen wird. Der Ballonspeicher 28 erfährt von außen den Atmosphärendruck und bläht sich im Betrieb durch einfließendes Helium gegen den Atmosphärendruck etwas auf, so dass der Druck im Inneren des Ballonspeichers 28 geringfügig über dem Atmosphärendruck liegt. An einem Ausgang des Ballonspeichers 28 ist ein Kompressor 29 angeschlossen, der Helium aus dem Ballonspeicher komprimieren kann (beispielsweise auf einen Druck von bis zu 200 bar) und das komprimierte Heliumgas in Druckgasflaschen 30 speichert.

Das NMR-Messsystem 20 umfasst neben der Kryostatenanordnung 21 weiterhin den supraleitenden NMR-Magneten 23 im Heliumtank 2, und weiterhin einen NMR-Probenkopf 31, der in eine Raumtemperaturbohrung 22a des Vakuumtanks 22 bzw. des vakuumisolierten Heliumtanks 2 einragt. Zudem gehört zur NMR-Messanordnung 20 auch eine NMR-Spektrometer-Steuereinrichtung 32, mit der NMR-Messungen mit dem NMR-Probenkopf 31 angesteuert werden können. NMR-messungen können an Proben durchgeführt werden, die in eine Probenvolumen 33 im Bereich des äußeren Endes des NMR-Probenkopfs 31 angeordnet werden, typischerweise wobei die Proben über ein Probenzuführsystem von oben in die Raumtemperaturbohrung 22 eingeführt werden (Probenzuführsystem nicht dargestellt). Die NMR-Spektrometer-Steuereinrichtung 32 erhält zudem Informationen über den Status der Regelung des Heliumtankdrucks von der elektronischen Regeleinrichtung 13.

Die **Figur 7** illustriert in einem Beispiel den Verlauf einer ersten Variante eines erfindungsgemäßen Verfahrens zur Steuerung des Drucks in einem Heliumtank für einen Sonderbetrieb anhand eines Diagramms (für den Normalbetrieb gemäß der Erfindung siehe Fig. 9). Nach rechts ist die Zeit anhand von beispielhaften Uhrzeiten aufgetragen. Nach oben sind der gemessene Druck aufgetragen (für die gestrichelte Kurve 71 der Druck im Heliumtank, also die ersten Druckwerte D1, und weiterhin für die durchgezogene Kurve 72 der gemessene Atmosphärendruck, also die zweiten Druckwerte D2) und der gemessene Heliumdurchfluss (Heliumdurchfluss-Werte, gepunktete Kurve 73). In der Variante soll für ein Nachfüllen von flüssigem Helium ein Öffnen des Heliumtanks gegen den Atmosphärendruck vorbereitet werden, und der Heliumtankdruck soll entsprechend überführt/abgesenkt werden. Man beachte, dass die Fig. 7 mit experimentellen Messwerten erhalten wurde.

### Kurzüberblick

Vor Beginn der Absenkung im Zeitraum 7:00 h bis ca. 11:00 h findet noch Normalbetrieb am Heliumtank statt, während dessen zB NMR-Messungen stattfinden können. Der Sollwert für den Heliumtankdruck ist auf 985 mbar eingestellt, und die gemessenen Heliumtankdruckwerte der Kurve 71 liegen sehr genau bei 985 mbar. Der gemessene Atmosphärendruck der Kurve 72 schwankt geringfügig um einen Wert von hier ca. 965 mbar. Der leichte Überdruck im Heliumtank verhindert ein Einsaugen von Verunreinigungen (insbesondere von feuchter Luft). In diesem Normalbetrieb fließt ein vergleichsweise kleiner, näherungsweise konstanter Strom von Heliumgas von ca. 10 ml/h Flüssigkeitsäquivalent durch das Stellventil ab; die mit der Verdampfung dieser Menge Heliums verbundene Kühlleistung gleicht die Wärmelast auf den Kryostaten aus.

Um 11:00 Uhr beginnt nun die Absenkung des Drucks im Heliumtank. Die Absenkung ist so programmiert, dass der Sollwert des Heliumtankdrucks mit konstanter Absenkgeschwindigkeit (also mit einer linearen Rampe) von hier ca. 3,66 mbar/h vom bisherigen Sollwert von 985 mbar bis auf den Atmosphärendruck als Zielwert abgesenkt wird. Die Absenkgeschwindigkeit und der Regelkreis insgesamt sind so eingerichtet, dass der Heliumtankdruck bzw. die ersten Druckwerte D1 der Kurve 71 dem linear absinkenden Sollwert recht genau (prompt) folgen können. Um den Heliumtankdruck gemäß dem programmierten Sollwertverlauf abzusenken, öffnet die elektronische Regeleinrichtung das Stellventil deutlich weiter als im vorausgehenden Normalbetrieb, und der Heliumdurchfluss nimmt deutlich zu, hier auf bis zu 80 ml/h Flüssigkeitsäquivalent. Man beachte, dass sich während der laufenden Absenkung der Atmosphärendruck wie aus Kurve 72 ersichtlich ein wenig verringert, hier bis auf ca. 962 mbar gegen 17:00 h.

Um kurz nach 17:00 Uhr erreicht der programmierte Sollwert den Atmosphärendruck, und die Regeleinrichtung überführt das Stellventil in eine weniger weit geöffnete Stellung. Aufgrund von Temperaturgradienten innerhalb des flüssigen Heliums im Heliumtank bleibt die Abdampfrate jedoch noch einige Zeit erhöht, und um den Druck im Heliumtank näherungsweise am Sollwert zu halten (der ab kurz nach 17:00 Uhr im Wesentlichen dem Atmosphärendruck entspricht) muss über das Stellventil ein entsprechendes Abfließen von Heliumgas durch eine entsprechende Ventilstellung gestattet werden. Gegen ca. 20:00 Uhr haben sich die Temperaturgradienten im Heliumtank ausgeglichen, und der Heliumdurchfluss erreicht wieder einen konstanten, niedrigen Wert von nun knapp unter 10 ml/h Flüssigkeitsäquivalent.

In dem erreichten Zustand kann der Heliumtank gegen die Atmosphäre geöffnet werden, ohne dass es zu einem energetisch ungünstigen, schlagartigen Verdampfen einer größeren Menge des flüssigen Heliums kommen würde.

### Detaillierte Erläuterung

Ein wesentlicher Vorteil, der sich aus der erfindungsgemäßen Verwendung von zwei Drucksensoren ergibt, ist, dass der Druck im Heliumtank (erster Druck) automatisch und in einem vom Benutzer bestimmbaren Zeitintervall an den zweiten Druck (z.B. den Atmosphärendruck oder den Druck im Heliumrückgewinnungssystem) angepasst werden kann. Dies ist zum Beispiel vor einem Heliumtransfer gewünscht. Für einen Heliumtransfer muss eine Öffnung, die Zugang zum Heliumtank gewährt, geöffnet werden, um die Transferleitung einführen zu können. Dabei entweicht Heliumgas aus dem Heliumtank - typischerweise so schnell, dass sich der Heliumtank auf Atmosphärendruck entspannt. Die schnelle Druckänderung birgt eine gewisse Gefahr für den Magneten (es besteht die Möglichkeit, dass der Magnet quencht), und zum anderen ist sie thermodynamisch ineffizient, da die Enthalpie des kalten Heliumgases beim schnellen Ausströmen ungenutzt bleibt.

Im Rahmen der Erfindung kann der Druck im Heliumtank langsam und zielgenau abgesenkt werden; insbesondere kann mit der Druckabsenkung am Vortag vor dem geplanten Heliumtransfer begonnen werden. Dies ist energetisch günstiger als eine "schlagartige" Entspannung. Ein Beispiel einer Druckabsenkung über eine vorgegebene Zeitdauer von 6 Stunden ist in der Fig. 7 dargestellt. Die durchgezogene Linie (Kurve 72) zeigt den Atmosphärendruck, die gestrichelte Linie (Kurve 71) den Druck im Heliumtank, und die gepunktete Linie (Kurve 73) den Heliumdurchfluss.

Es ist anhand der Kurve 73 gut zu sehen, dass der Heliumdurchfluss nach Beginn der Druckabsenkung gegen 11:00 Uhr zunächst nur langsam ansteigt, dann während der weiteren Druckabsenkung weiter zunimmt (obwohl die Druckabsenkung linear ist), und dann nach Abschluss der Druckabsenkung gegen 17:00 Uhr weiterhin für mehrere Stunden erhöht bleibt.

Druck und Temperatur des siedenden Heliums im Heliumtank sind über die Dampfdruckkurve miteinander verbunden. Die gilt allerdings nur für die Flüssigkeit an der Oberfläche, da Helium eine verhältnismäßig schlechte Wärmeleitfähigkeit hat. Innerhalb des flüssigen Heliums bildet sich bei Druckveränderungen zeitweilig ein Temperaturgradient aus.

Wenn der Druck wie im illustrierten Beispiel oben im Heliumtank schnell abgesenkt wird, sinkt die Temperatur des flüssigen Heliums an der Oberfläche, und das flüssige Helium unterhalb der Oberfläche bleibt wärmer und kühlt nur langsam auf die Oberflächentemperatur ab. Während dieser Zeit verdampft mehr flüssiges Helium als die Wärmelast auf den Heliumtank erwarten ließe, da dem Helium unterhalb der Oberfläche zum Abkühlen Energie entzogen werden muss. Die Kühlleistung wird von erhöhter Verdampfung bereitgestellt. Nachdem die Druckabsenkung vollzogen ist, ist das Helium unter unterhalb der Oberfläche meist noch nicht im thermischen Gleichgewicht mit der Oberfläche, und die Verdampfungsrate (bzw. der gemessene Heliumdurchfluss) ist auch nach Abschluss der Druckabsenkung noch für einige Zeit erhöht.

Dieser Effekt ist stark zeitabhängig - je schneller die Druckabsenkung durchgeführt wird, desto ausgeprägter ist der Effekt, da weniger Zeit ist, um innerhalb des Flüssigkeitsvolumens dem thermischen Gleichgewicht nahezukommen.

Es ist besonders vorteilhaft, den Heliumdurchfluss während der Druckabsenkung möglichst konstant zu halten, da so die Enthalpie des kalten Gases optimal genutzt werden kann. Beim Absenken des Drucks im Heliumtank ist es deshalb vorteilhaft, den Druck anfänglich schneller abzusenken (um die anfängliche Verdampfung künstlich zu beschleunigen), und den Druck gegen Ende der Druckabsenkungphase langsamer zu reduzieren (um die Verdampfungsrate konstant zu halten). Dies kann mit der erfindungsgemäßen Vorrichtung eingerichtet werden. Die **Figur 8** illustriert hierzu eine zweite Variante eines erfindungsgemäßen Verfahrens zur Druckregelung in einem Heliumtank für einen Sonderbetrieb.

Das Diagramm der Fig. 8 trägt nach rechts die Zeit (in beliebigen Einheiten) auf, und nach oben den Druck (in Kurve 81 den ersten Druck/erste Druckwerte D1 im Heliumtank, und in Kurve 82 den Atmosphärendruck/zweite Druckwerte D2) und den Heliumdurchfluss durch das Stellventil (Kurve 83, Heliumdurchfluss-Werte).

Vor dem Zeitpunkt t1 herrscht noch Normalbetrieb, und der Sollwert des Heliumtankdrucks liegt bei hier 1000 mbar, und die ersten Druckwerte D1 der Kurve 81 liegen konstant entsprechend bei diesem Sollwert. Der Atmosphärendruck der Kurve 82 liegt bei 970 mbar; der Atmosphärendruck bleibt hier über den gesamten Betrachtungszeitraum konstant. Der Heliumdurchfluss liegt zunächst bei niedrigen 15 ml/h Flüssigkeitsäquivalent.

Beginnend ab Zeitpunkt t1 und über den Absenkzeitraum bis Zeitpunkt t2 wird der Sollwert des Heliumtankdrucks gemäß einer nicht-linearen Rampe auf den Atmosphärendruck abgesenkt; die ersten Druckwerte D1 der Kurve 81 folgen prompt dem Sollwert gemäß der Einregelung. Zu Beginn des Absenkzeitraums ist dabei die Druckabsenkung pro Zeiteinheit noch relativ groß, und nimmt dann bis zum als am Ende des Absenkzeitraums immer weiter ab. Durch entsprechende Wahl des Verlaufs der Sollwertänderung kann erreicht werden, dass der Heliumdurchfluss über den gesamten Absenkungszeitraum von t1 bis t2 näherungsweise konstant bleibt, im gezeigten Beispiel bei ca. 30 ml/h Flüssigkeitsäquivalent wie in Kurve 83 ersichtlich. Zum Zeitpunkt t2 kann dann das Stellventil wieder so weit geschlossen werden, dass sich erneut ein niedriger Heliumdurchfluss von 15 ml/h Flüssigkeitsäquivalent einstellt.

Das Vorgehen gemäß Fig. 7 mit allmählicher linearer Sollwertabsenkung erreicht energetisch bereits eine deutliche Verbesserung gegenüber einer plötzlichen Druckabsenkung beim Öffnen des Heliumtanks, und mit dem Vorgehen gemäß Fig. 8 mit nicht-linearer Sollwertabsenkung kann noch eine weitere Steigerung der energetischen Effizienz erreicht werden.

Die **Figur 9** zeigt eine dritte Variante des erfindungsgemäßen Verfahrens zur Regelung des Drucks in einem Heliumtank für einen Normalbetrieb gemäß der Erfindung. Das Diagramm trägt nach rechts die Zeit (in beliebigen Einheiten) auf, und nach oben den Druck auf (mit Kurve 91 darstellend den ersten Druck/Heliumtankdruck mit ersten Druckwerten D1, die mit guter Genauigkeit der Kurve 93 des Sollwerts des Drucks im Heliumtank entspricht, und weiterhin mit Kurve 92 darstellend den zweiten Druck/Atmosphärendruck mit zweiten Druckwerten D2).

Im Rahmen der dritten Variante wird für den Normalbetrieb des NMR-Magneten der Heliumtankdruck stabilisiert, um in NMR-Messungen Messartefakte zu minimieren, und gleichzeitig den Wetterverhältnissen Rechnung zu tragen, so dass eine hohe Betriebssicherheit erreicht wird. Die elektronische Regeleinrichtung legt dafür den Sollwert des Heliumtankdrucks fest, und nimmt insbesondere auch Änderungen des Sollwerts für den Heliumtankdruck vor, wobei sie den zweiten Druck, hier den Atmosphärendruck, auswertet.

Im Rahmen des Normalbetriebs soll der Heliumtankdruck während NMR-Messungen konstant bleiben, da Druckschwankungen Dimensionsänderungen im Messsystem auslösen können, die beispielsweise die Probenposition relativ zum Magneten verändern oder auch den Magneten in sich verzerren können. Entsprechend wird der Sollwert des Heliumtankdrucks (vgl. Kurve 93) die meiste Zeit auf einem kontanten Wert gehalten, hier in den Zeiträumen von t1 bis t2, von t3 bis t4, von t5 bis t6, und ab t7; der Heliumtankdruck (vgl. Kurve 91) folgt dem Sollwert recht exakt/prompt. Während dieser Zeiträume können NMR-Messungen unter stabilen Messbedingungen durchgeführt werden.

Weiterhin sollte der Heliumtankdruck (vgl. Kurve 91) stets deutlich über dem Atmosphärendruck (vgl. Kurve 92) liegen, um ein Einsaugen von Verunreinigungen (etwa feuchte Luft) in den Heliumtank zu verhindern. Wenn der Atmosphärendruck ansteigt, kommt dieser näher an den Heliumtankdruck bzw. den Sollwert heran. Im illustrierten Beispiel ist vorgesehen, die aktuelle Differenz DIF zwischen dem Heliumtankdruck (mit Druckwerten D1) und dem Atmosphärendruck (mit Druckwerten D2) zu prüfen und mit einem Anhebeschwellwert HSW zu vergleichen. Mit DIF=D1-D2 wird überprüft, ob DIF≤HSW geworden ist. Falls ja, wird der Sollwert (vgl. Kurve 93) um eine Stufe angehoben, wobei eine Stufe hier 20 mbar beträgt. Vorliegend wird DIF bei Zeitpunkt t2 kleiner als HSW, und der bisherige Sollwert von 980 mbar vor t2 wird auf einen neuen Sollwert von 1000 mbar ab t3 angehoben. Zwischen t2 und t3 wird der Sollwert (Kurve 93) mit einer hier linearen Anhebekurve angehoben, so dass der Heliumtankdruck (Kurve 91) dieser Änderung gut/prompt folgen kann. Ab Zeitpunkt t3 bleiben dann der Sollwert und der Heliumtankdruck wieder konstant, hier bis t4, trotz diverser Schwankungen in der Kurve 92.

Weiterhin sollte sichergestellt werden, dass der Überdruck in Heliumtank gegenüber der umgebenden Atmosphäre nicht zu groß wird. Keinesfalls darf der Heliumtank wegen Überdruck explodieren. Um dies sicherzustellen, verfügt der Heliumtank über Überdruckventile, die ab einer gewissen Differenz öffnen und Helium ablassen, und als weitere Sicherheitsstufe gibt es Berstscheiben, über die (nach dem Bersten der Scheiben) auch große Mengen Heliumgas aus dem Heliumtank abfließen können, insbesondere im Falle eines Quenchs. Das Auslösen der Sicherheitseinrichtungen sollte aber unvorhergesehenen Notfällen vorbehalten bleiben. Im illustrierten Beispiel ist daher weiterhin vorgesehen, die aktuelle Differenz DIF zwischen dem Heliumtankdruck (mit Druckwerten D1) und dem Atmosphärendruck (mit Druckwerten D2) zu prüfen und mit einem Absenkschwellwert SSW zu vergleichen. Mit DIF=D1-D2 wird überprüft, ob DIF≥SSW geworden ist. Falls ja, wird der Sollwert (vgl. Kurve 93) um eine Stufe abgesenkt, wobei eine Stufe hier ebenfalls 20 mbar beträgt. Vorliegend wird DIF bei t4 größer als SSW, und der bisherige Sollwert von 1000 mbar vor t4 wird auf einen neuen Sollwert von 980 mbar ab t5 abgesenkt. Zwischen t4 und t5 wird der Sollwert (Kurve 93) mit einer hier linearen Absenkkurve abgesenkt, so dass der Heliumtankdruck (Kurve 91) dieser Änderung gut/prompt folgen kann. Ab Zeitpunkt t5 bleiben dann der Sollwert und der Heliumtankdruck wieder konstant, hier bis t6. Weiterhin wird dann DIF bei t6 abermals größer als SSW, und der bisherige Sollwert von 980 mbar vor t4 wird auf einen neuen Sollwert von 960 mbar ab t7 abgesenkt. Zwischen t6 und t7 wird der Sollwert (Kurve 93) mit einer hier linearen Absenkkurve abgesenkt, so dass der Heliumtankdruck (Kurve 91) dieser Änderung gut/prompt folgen kann. Ab Zeitpunkt t7 bleiben dann der Sollwert und der Heliumtankdruck wieder konstant.

In den jeweiligen Zeiten der Sollwertveränderung, also von t2 bis t3, weiter von t4 bis t5, und weiter von t6 bis t7, werden wegen instabiler Druckverhältnisse (veränderlichen Drucks) im Heliumtank keine NMR-Messungen durchgeführt. Die elektronische Regeleinrichtung meldet die laufende Sollwertänderung bzw. Druckinstabilität an die NMR-Spektrometer-Steuereinrichtung, die für diese Zeiten Messpausen einrichtet.

Die **Figur 10** illustriert in einem schematischen Ablaufdiagramm eine beispielhafte Überwachung des korrekten Betriebs einer erfindungsgemäßen Vorrichtung zur Regelung des Drucks in einem Heliumtanks bzw. einer zugehörigen NMR-Messanordnung anhand einer Alarmsituation für eine Vereisungsüberwachung für den Kryostaten. Andere Alarmsituationen können in analoger Weise überwacht werden. Die Vorrichtung ist beispielsweise wie in Fig. 5 dargestellt ausgebildet, bzw. die NMR-Messanordnung wie in Fig. 6 dargestellt.

Nach dem Start 100 der Überwachung wird mit dem Durchflussmesser der aktuelle Heliumdurchfluss-Wert gemessen 200. Der ausgelesene Heliumdurchfluss-Wert wird sodann mit einem Heliumdurchfluss-Wert von "null" verglichen 300. Ist der gemessene Heliumdurchfluss-Wert größer null, so erfolgt (im Rahmen einer kontinuierlichen Überwachung) eine erneute Messung des Heliumdurchfluss-Werts 200 und so fort.

Ist der gemessene Heliumdurchfluss-Wert gleich null, so erfolgt eine Bestimmung der von der Regeleinrichtung angesteuerten Stellung des Stellventils 400. Die angesteuerte Stellung wird sodann mit einer (vollständig) geschlossenen Stellung verglichen 500. Wenn die angesteuerte Stellung des Stellventils eine (vollständig) geschlossene Stellung ist, so kann davon ausgegangen werden, dass gemäß der Programmierung der Regeleinrichtung derzeit der Druck im Heliumtank angehoben werden soll, und daher planmäßig das Stellventil geschlossen ist und planmäßig der Heliumdurchfluss gerade blockiert werden soll; die Überwachung wird dann (im Rahmen der kontinuierlichen Überwachung) mit einer nächsten Messung des Heliumdurchfluss-Werts 200 fortgesetzt.

Wenn die angesteuerte Stellung des Stellventils nicht eine (vollständig) geschlossene Stellung ist, so muss davon ausgegangen werden, dass eine unerwünschte und gefährliche Blockade des Heliumflusses durch Vereisung des Kryostaten bzw. der vom Heliumtank abgehenden Heliumleitung vorliegt. Entsprechend erfolgt dann die Ausgabe einer Alarmmeldung 600. Ausgehend von der Alarmmeldung 600 können dann manuelle oder automatische Gegenmaßnahmen oder Sicherungsmaßnahmen ergriffen werden.

### Bezugszeichenliste

- 1: Vorrichtung
- 2: Heliumtank
- 3: vom Heliumtank abgehende Heliumleitung
- 4: Heliumrückgewinnungssystem
- 5: Stellventil
- 6: erster Drucksensor (für Heliumtankdruck)
- 7: zweiter Drucksensor (hier: Differenzdruckmesser, für Atmosphärendruck)
- 7a: zweiter Drucksensor (hier: Differenzdruckmesser, für Druck im Heliumregenerationssystem)
- 8: Drossel (in Heliumleitung 3)
- 9: dritter Drucksensor (hier: Differenzdruckmesser, für Druck im Heliumregenerationssystem)
- 10: weiterer Leitungsstrang
- 11: Absperrventil
- 12: Drossel (im weiteren Leitungsstrang 10)
- 13: elektronische Regeleinrichtung
- 14: Durchflusssensor
- 15: Alarmeinrichtung
- 16: akustischer und optischer Signalgeber
- 17: Speichereinrichtung
- 20: NMR-Messanordnung
- 21: Kryostatenanordnung
- 22: evakuierter Behälter/Vakuumtank
- 22a: Raumtemperaturbohrung
- 23: supraleitender NMR-Magnet
- 24: Halsrohre
- 25: vorderer Abschnitt der Heliumleitung
- 26: mittlerer Abschnitt der Heliumleitung in der Vorrichtung
- 27: hinterer Abschnitt der Heliumleitung
- 28: Ballonspeicher
- 29: Kompressor
- 30: Druckgasflaschen
- 31: NMR-Probenkopf
- 32: NMR-Spektrometer-Steuereinrichtung
- 33: Probenvolumen
- 71: Kurve erste Druckwerte (Heliumtankdruck)
- 72: Kurve zweite Druckwerte (Atmosphärendruck)
- 73: Kurve Heliumdurchfluss-Werte
- 81: Kurve erste Druckwerte (Heliumtankdruck)
- 82: Kurve zweite Druckwerte (Atmosphärendruck)
- 83: Kurve Heliumdurchfluss-Werte
- 91: Kurve erste Druckwerte (Heliumtankdruck)
- 92: Kurve zweite Druckwerte (Atmosphärendruck)
- 93: Kurve Sollwert für Heliumtankdruck
- 100: Start
- 200: Messung Heliumdurchfluss-Wert
- 300: Vergleich Heliumdurchfluss-Wert mit null
- 400: Bestimmung angesteuerte Stellung des Stellventils
- 500: Vergleich angesteuerte Stellung des Stellventils mit (vollständig) geschlossener Stellung
- 600: Alarmmeldung
- atm: umgebende Atmosphäre
- D1: erste Druckwerte (Heliumtankdruck)
- D2: zweite Druckwerte (hier meist Atmosphärendruck)
- D3: dritte Druckwerte
- DIF: Differenz von erstem Druckwert und zweitem Druckwert, DIF=D1-D2
- HSW: Anhebeschwellwert
- SSW: Absenkschwellwert
- t1-t7: Zeitpunkte

## Patentansprüche

1. Vorrichtung (1) zur Regelung des Drucks in einem Heliumtank (2) eines NMR-Magneten (23), umfassend
- einen ersten Drucksensor (6) zur Messung eines ersten Drucks im Heliumtank (2),
- zumindest einen zweiten Drucksensor (7; 7a) zur Messung eines zweiten Drucks außerhalb des Heliumtanks (2),
- ein Stellventil (5) zur Einstellung eines abfließenden Heliumgasstroms aus dem Heliumtank (2),
- eine elektronische Regeleinrichtung (13) zur Ansteuerung des Stellventils (5),
wobei die elektronische Regeleinrichtung (13) dazu eingerichtet ist,
- vom ersten Drucksensor (6) gemessene erste Druckwerte D1 zu erhalten,
- und eine Stellung des Stellventils (5) in Abhängigkeit von den gemessenen ersten Druckwerten D1 einzustellen, wobei die ersten Druckwerte D1 auf einen vorgegebenen Sollwert SW eingeregelt werden,
- vom zweiten Drucksensor (7; 7a) gemessene zweite Druckwerte D2 zu erhalten,
und wobei die elektronische Regeleinrichtung (13) weiterhin dazu eingerichtet ist, in einem Normalbetrieb für NMR-Messungen
- den Sollwert SW in Abhängigkeit von den ersten Druckwerten D1 und den zweiten Druckwerten D2 zu ermitteln,
- nämlich den Sollwert SW für den Druck im Heliumtank (2) stufenweise zu verändern, sobald eine Differenz DIF=D1-D2 zwischen dem gemessenen ersten Druckwert D1 und dem gemessenen zweiten Druckwert D2 vorgegebene Schwellwerte erreicht oder überschreitet,
wobei der Sollwert SW um eine Stufe angehoben wird, wenn die Differenz DIF kleiner oder gleich einem Anhebeschwellwert HSW wird, und der Sollwert SW um eine Stufe abgesenkt wird, wenn die Differenz DIF größer oder gleich einem Absenkschwellwert SSW wird, mit HSW<SSW,
und wobei eine jeweilige Stufe, um die der Sollwert SW verändert wird, sobald die Differenz DIF=D1-D2 zwischen dem gemessenen ersten Druckwert D1 und dem gemessenen zweiten Druckwert D2 die vorgegebenen Schwellwerte erreicht oder überschreitet, im Bereich 5-25 mbar gewählt ist.

2. Vorrichtung (1) nach Anspruch 1, **dadurch gekennzeichnet, dass** der zweite Druck ein Druck in der umgebenden Atmosphäre (atm) ist.

3. Vorrichtung (1) nach Anspruch 1, **dadurch gekennzeichnet, dass** der zweite Druck ein Druck in einem Heliumrückgewinnungssystem (4) ist.

4. Vorrichtung (1) nach Anspruch 1, **dadurch gekennzeichnet, dass** die Vorrichtung (1) weiterhin umfasst
- einen dritten Drucksensor (9) zur Messung eines dritten Drucks außerhalb des Heliumtanks (2),
wobei der zweite Druck und der dritte Druck einen Druck in der umgebenden Atmosphäre (atm) und einen Druck in einem Heliumrückgewinnungssystem (4) umfassen.

5. Vorrichtung (1) nach einem der vorhergehenden Ansprüche, **dadurch gekennzeichnet, dass** die Vorrichtung (1) weiterhin umfasst
- einen Durchflusssensor (14) zur Messung eines Heliumdurchfluss-Werts des abfließenden Heliumgasstroms aus dem Heliumtank (2).

6. Vorrichtung (1) nach einem der vorhergehenden Ansprüche, **dadurch gekennzeichnet, dass** die Regeleinrichtung (13) eine Speichereinrichtung (17) oder einen Anschluss für eine Speichereinrichtung (17) umfasst, mit welcher von der Regeleinrichtung (13) erhaltene Sensorwerte aufgezeichnet werden.

7. Vorrichtung (1) nach einem der vorhergehenden Ansprüche, **dadurch gekennzeichnet,**
**dass** die Regeleinrichtung (13) dazu eingerichtet ist, in einem Sonderbetrieb für das Nachfüllen von flüssigem Helium
- den Sollwert SW für den Druck im Heliumtank (2) über eine vorgegebene Zeitdauer auf einen Zielwert ZW zu überführen, wobei der Zielwert ZW vom zweiten Druckwert D2 abhängig ist,
insbesondere wobei die Zeitdauer von einem Benutzer ausgewählt werden kann.

8. Vorrichtung (1) nach Anspruch 7, **dadurch gekennzeichnet,**
**dass** der Zielwert ZW dem zweiten Druckwert D2 entspricht mit ZW=D2, oder der Zielwert ZW um einen kleinen Druckaufschlag DA über dem zweiten Druckwert D2 liegt mit ZW=D2+DA und mit DA≤3 mbar.

9. Vorrichtung (1) nach Anspruch 7 oder 8, **dadurch gekennzeichnet, dass** die Regeleinrichtung (13) dazu eingerichtet ist, in dem Sonderbetrieb für das Nachfüllen von flüssigem Helium den Sollwert SW linear mit der Zeit auf den Zielwert ZW zu überführen.

10. Vorrichtung (1) nach Anspruch 7 oder 8, **dadurch gekennzeichnet, dass** die Regeleinrichtung (13) dazu eingerichtet ist, in dem Sonderbetrieb für das Nachfüllen von flüssigem Helium den Sollwert SW nicht-linear mit der Zeit zu ändern, wobei ein Heliumdurchfluss durch das Stellventil (5) während der Dauer des Überführens des Sollwerts SW auf den Zielwert ZW näherungsweise konstant gehalten wird.

11. Vorrichtung (1) nach Anspruch 10, **dadurch gekennzeichnet, dass** die Regeleinrichtung (13) dazu eingerichtet ist, in dem Sonderbetrieb für das Nachfüllen von flüssigem Helium beim Überführen des Sollwerts SW auf den Zielwert ZW den Sollwert SW am Anfang des Überführens schneller abzusenken als gegen Ende des Überführens.

12. Vorrichtung (1) nach einem der vorhergehenden Ansprüche, **dadurch gekennzeichnet,**
**dass** die Vorrichtung (1) weiterhin eine Alarmeinrichtung (15) umfasst, mit der in einer oder mehreren vorgegebenen Alarmsituationen automatisch eine Alarmmeldung ausgelöst wird (600),
insbesondere wobei die Alarmeinrichtung (15) einen akustischen Signalgeber (16) und/oder einen optischen Signalgeber (16) und/oder einen Funksignalgeber und/oder einen Datensignalgeber umfasst.

13. Vorrichtung (1) nach Anspruch 12 und nach einem der Ansprüche 2 oder 4, **dadurch gekennzeichnet, dass** eine Alarmsituation umfasst, dass der Druckwert D1 des Heliumtankdrucks (2) unter den Druckwert D2 des Atmosphärendrucks fällt.

14. Vorrichtung (1) nach Anspruch 12 oder 13, **dadurch gekennzeichnet, dass** eine Alarmsituation umfasst, dass der Druckwert D1 des Heliumtankdrucks einen vorgegebenen Heliumtankdruck-Maximalwert überschreitet, insbesondere wobei eine erste Alarmsituation zu D1 umfasst, dass der Druckwert D1 des Heliumtankdrucks einen vorgegebenen ersten Heliumtankdruck-Maximalwert EHM überschreitet, eine zweite Alarmsituation zu D1 umfasst, dass der Druckwert D1 des Heliumtankdrucks einen vorgegebenen zweiten Heliumtankdruck-Maximalwert ZHM überschreitet, und ZHM>EHM, und die Alarmmeldungen zur ersten Alarmsituation zu D1 und zur zweiten Alarmsituation zu D1 unterschiedlich sind.

15. Vorrichtung (1) nach einem der Ansprüche 12 bis 14 und nach Anspruch 5, **dadurch gekennzeichnet, dass** eine Alarmsituation umfasst, dass ein gemessener Heliumdurchfluss-Wert einen vorgegebenen Heliumdurchfluss-Maximalwert überschreitet.

16. Vorrichtung (1) nach Anspruch 15, **dadurch gekennzeichnet, dass** der vorgegebene Heliumdurchfluss-Maximalwert von derzeit oder vor kurzer Zeit angesteuerten Änderungen des Heliumtankdrucks abhängt,
insbesondere wobei der Heliumdurchfluss-Maximalwert während und/oder kurz nach vorgenommenen Absenkungen des Heliumtankdrucks höher ist als bei konstant angesteuertem Heliumtankdruck.

17. Vorrichtung (1) nach einem der Ansprüche 12 bis 16 und nach Anspruch 5, **dadurch gekennzeichnet, dass** eine Alarmsituation umfasst, dass ein gemessener Heliumdurchfluss-Wert einen vorgegebenen Heliumdurchfluss-Minimalwert unterschreitet.

18. Vorrichtung (1) nach Anspruch 17, **dadurch gekennzeichnet, dass** der vorgegebene Heliumdurchfluss-Minimalwert von derzeit oder vor kurzer Zeit angesteuerten Änderungen des Heliumtankdrucks abhängt,
insbesondere wobei der Heliumdurchfluss-Minimalwert während und/oder kurz nach vorgenommenen Erhöhungen des Heliumtankdrucks niedriger ist als bei konstant angesteuertem Heliumtankdruck.

19. Vorrichtung (1) nach einem der Ansprüche 12 bis 18 und nach Anspruch 5, **dadurch gekennzeichnet, dass** eine Alarmsituation umfasst, dass ein gemessener Heliumdurchfluss-Wert null beträgt und gleichzeitig eine aktuelle Stellung des Stellventils (5) oder eine von der Regeleinrichtung (13) aktuell angesteuerte Stellung des Stellventils (5) nicht geschlossen ist.

20. Vorrichtung (1) nach einem der Ansprüche 12 bis 19 und nach Anspruch 5 und nach einem der Ansprüche 3 oder 4, **dadurch gekennzeichnet, dass** eine Alarmsituation umfasst, dass ein gemessener Heliumdurchfluss-Wert null beträgt und gleichzeitig ein Druckwert D2 im Heliumrückgewinnungssystem (4) bis auf den Druckwert D1 im Heliumtank (2) angestiegen ist.

21. Vorrichtung (1) nach einem der Ansprüche 12 bis 20 und nach Anspruch 4, **dadurch gekennzeichnet, dass** eine Alarmsituation umfasst, dass eine Differenz DHA=DHR-DAT eines gemessenen Druckwerts DHR im Heliumrückgewinnungssystem (4) und eines gemessenen Druckwerts DAT in der umgebenden Atmosphäre (atm) einen vorgegebenen Schwellwert SWW überschreitet, insbesondere wobei SWW gewählt ist in einem Bereich von 2,5 mbar bis 20 mbar.

22. Vorrichtung (1) nach einem der Ansprüche 12 bis 21, **dadurch gekennzeichnet, dass** zumindest ein Teil der Alarmsituationen eine aktuelle Stellung des Stellventils (5) oder eine von der Regeleinrichtung (13) aktuell angesteuerte Stellung des Stellventils (5) einbezieht.

23. Verfahren zur Regelung des Drucks in einem Heliumtank (2) eines NMR-Magneten (23),
wobei mit einem ersten Drucksensor (6) ein erster Druck im Heliumtank (2) gemessen wird,
wobei mit einem Stellventil (5) ein abfließender Heliumgasstrom aus dem Heliumtank (2) eingestellt wird,
wobei eine elektronische Regeleinrichtung (13) das Stellventil (5) ansteuert,
wobei mit zumindest einem zweiten Drucksensor (7; 7a) ein zweiter Druck außerhalb des Heliumtanks (2) gemessen wird,
wobei die elektronische Regeleinrichtung (13)
- vom ersten Drucksensor (6) gemessene erste Druckwerte D1 erhält,
- und eine Stellung des Stellventils (5) in Abhängigkeit von den gemessenen ersten Druckwerten D1 einstellt, so dass die ersten Druckwerte D1 auf einen vorgegebenen Sollwert SW eingeregelt werden,
- und vom zweiten Drucksensor (7; 7a) gemessene zweite Druckwerte D2 erhält,
und wobei die elektronische Regeleinrichtung (13) weiterhin in einem Normalbetrieb für NMR-Messungen
- den Sollwert SW in Abhängigkeit von den gemessenen ersten Druckwerten D1 und zweiten Druckwerten D2 ermittelt,
- nämlich den Sollwert SW für den Druck im Heliumtank (2) stufenweise verändert, sobald eine Differenz DIF=D1-D2 zwischen dem gemessenen ersten Druckwert D1 und dem gemessenen zweiten Druckwert D2 vorgegebene Schwellwerte erreicht oder überschreitet,
wobei der Sollwert SW um eine Stufe angehoben wird, wenn die Differenz DIF kleiner oder gleich einem Anhebeschwellwert HSW wird, und der Sollwert um eine Stufe abgesenkt wird, wenn die Differenz DIF größer oder gleich einem Absenkschwellwert SSW wird, mit HSW<SSW,
und wobei eine jeweilige Stufe, um die der Sollwert SW verändert wird, sobald die Differenz DIF=D1-D2 zwischen dem gemessenen ersten Druckwert D1 und dem gemessenen zweiten Druckwert D2 die vorgegebenen Schwellwerte erreicht oder überschreitet, im Bereich 5-25 mbar gewählt wird,
insbesondere wobei das Verfahren unter Verwendung einer Vorrichtung (1) nach einem der vorhergehenden Ansprüche durchgeführt wird.

24. Verfahren nach Anspruch 23, **dadurch gekennzeichnet,**
**dass** die Regeleinrichtung (13) in einem Sonderbetrieb für das Nachfüllen von flüssigem Helium den Sollwert SW für den Druck im Heliumtank (2) über eine vorgegebene Zeitdauer auf einen Zielwert ZW überführt, wobei der Zielwert ZW vom zweiten Druckwert D2 abhängig ist,
insbesondere wobei die Zeitdauer von einem Benutzer ausgewählt werden kann,
insbesondere wobei das Verfahren unter Verwendung einer Vorrichtung (1) nach Anspruch 9 durchgeführt wird.

25. Verfahren nach Anspruch 24, **dadurch gekennzeichnet,**
**dass** die Regeleinrichtung (13) in dem Sonderbetrieb für das Nachfüllen von flüssigem Helium den Sollwert SW nicht-linear mit der Zeit ändert, wobei ein Heliumdurchfluss durch das Stellventil (5) während der Dauer des Überführens des Sollwerts SW auf den Zielwert ZW näherungsweise konstant gehalten wird,
insbesondere wobei das Verfahren unter Verwendung einer Vorrichtung (1) nach Anspruch 10 durchgeführt wird.

26. Verfahren nach einem der Ansprüche 23 bis 25, **dadurch gekennzeichnet, dass** mit einer Alarmeinrichtung (15) in einer oder mehreren vorgegebenen Alarmsituationen automatisch eine Alarmmeldung ausgelöst wird (600),
insbesondere wobei die Alarmeinrichtung (15) einen akustischen Signalgeber (16) und/oder einen optischen Signalgeber (16) und/oder einen Funksignalgeber und/oder einen Datensignalgeber umfasst,
und dass eine Alarmsituation umfasst, dass ein gemessener Heliumdurchfluss-Wert des abfließenden Heliumgasstrom aus dem Heliumtank (2) durch das Stellventil (5) null beträgt und gleichzeitig eine aktuelle Stellung des Stellventils (5) oder eine von der Regeleinrichtung (13) aktuell angesteuerte Stellung des Stellventils (5) nicht geschlossen ist,
insbesondere wobei das Verfahren unter Verwendung einer Vorrichtung (1) nach Anspruch 19 durchgeführt wird.

27. Kryostatenanordnung (21), umfassend
- einen vakuumisolierten Heliumtank (2),
- eine Vorrichtung (1) nach einem der Ansprüche 1 bis 22,
wobei der erste Drucksensor (6) mit dem Heliumtank (2) verbunden ist, und der zweite Drucksensor (7; 7a) mit einem Ort außerhalb des Heliumtanks (2) verbunden ist,
insbesondere wobei der zweite Drucksensor (7; 7a) mit der umgebenden Atmosphäre (atm) oder mit einem Heliumrückgewinnungssystem (4) verbunden ist,
und wobei das Stellventil (5) in einer vom Heliumtank (2) abgehenden Heliumleitung (3) angeordnet ist.

28. Kryostatenanordnung (21) nach Anspruch 27, **dadurch gekennzeichnet, dass** die Kryostatenanordnung (21) weiterhin ein Heliumrückgewinnungssystem (4) umfasst, welches an der abgehenden Heliumleitung (3) angeschlossen ist.

29. NMR-Messanordnung (20), umfassend
- eine Kryostatenanordnung (21) nach einem der Ansprüche 27 oder 28,
- einen supraleitenden NMR-Magneten (23) im Heliumtank (2) der Kryostatenanordnung (21),
- einen NMR-Probenkopf (31), der in eine Raumtemperaturbohrung (22a) des vakuumisolierten Heliumtanks (2) einragt, und
- eine NMR-Spektrometer-Steuereinrichtung (32), zur Ansteuerung von NMR-Messungen mit dem NMR-Probenkopf (31).

30. Verwendung einer NMR-Messanordnung (20) nach Anspruch 29 zur Durchführung von NMR-Messungen,
wobei die elektronische Regeleinrichtung (13) einen Status der Regelung des Heliumtankdrucks an die NMR-Spektrometer-Steuereinrichtung (32) kommuniziert,
und wobei während Zeiten von Druckinstabilität im Heliumtank (2) die NMR-Spektrometer-Steuereinrichtung (32) die NMR-Messungen pausiert.

## Claims

1. A device (1) for regulating the pressure in a helium tank (2) of an NMR magnet (23), comprising
- a first pressure sensor (6) for measuring a first pressure in the helium tank (2),
- at least one second pressure sensor (7; 7a) for measuring a second pressure outside the helium tank (2),
- a control valve (5) for adjusting an outflowing helium gas flow from the helium tank (2),
- an electronic control device (13) for controlling the control valve (5),
wherein the electronic control device (13) is configured to
- obtain first pressure values D1 measured by the first pressure sensor (6),
- and to adjust a position of the control valve (5) depending on the measured first pressure values D1, wherein the first pressure values D1 are adjusted to a predetermined setpoint value SW,
- obtain second pressure values D2 measured by the second pressure sensor (7; 7a),
and wherein the electronic control device (13) is further configured in a normal operating mode for NMR measurements
- to determine the setpoint value SW depending on the first pressure values D1 and the second pressure values D2,
- namely to change the setpoint value SW for the pressure in the helium tank (2) in steps as soon as a difference DIF=D1-D2 between the measured first pressure value D1 and the measured second pressure value D2 reaches or exceeds predetermined threshold values,
wherein the setpoint value SW is raised by one step when the difference DIF becomes less than or equal to an increase threshold value HSW, and the setpoint value SW is lowered by one step when the difference DIF becomes greater than or equal to a decrease threshold value SSW, with HSW<SSW, and wherein a respective step by which the setpoint value SW is changed as soon as the difference DIF=D1-D2 between the measured first pressure value D1 and the measured second pressure value D2 reaches or exceeds the predetermined threshold values is selected in the range 5-25 mbar.

2. The device (1) according to claim 1, **characterized in that** the second pressure is a pressure in the surrounding atmosphere (atm).

3. The device (1) according to claim 1, **characterized in that** the second pressure is a pressure in a helium recovery system (4).

4. The device (1) according to claim 1, **characterized in that** the device (1) further comprises
- a third pressure sensor (9) for measuring a third pressure outside the helium tank (2),
wherein the second pressure and the third pressure comprise a pressure in the ambient atmosphere (atm) and a pressure in a helium recovery system (4).

5. The device (1) according to any of the preceding claims, **characterized in that** the device (1) further comprises
- a flow sensor (14) for measuring a helium flow value of the outflowing helium gas flow from the helium tank (2).

6. The device (1) according to any of the preceding claims, **characterized in that** the control device (13) comprises a memory device (17) or a connection for a memory device (17) with which sensor values obtained by the control device (13) are recorded.

7. The device (1) according to any of the preceding claims, **characterized in that**
the control device (13) is configured in a special operating mode for refilling liquid helium
- to transfer the setpoint value SW for the pressure in the helium tank (2) to a target value ZW over a predetermined period of time, wherein the target value ZW is dependent on the second pressure value D2,
in particular wherein the period of time can be selected by a user.

8. The device (1) according to claim 7, **characterized in that**
the target value ZW corresponds to the second pressure value D2 with ZW=D2,
or the target value ZW is a small pressure increase DA above the second pressure value D2, with ZW=D2+DA and with DA≤3 mbar.

9. The device (1) according to claim 7 or 8, **characterized in that** the control device (13) is configured in the special operating mode for refilling liquid helium to transition the setpoint value SW linearly over time to the target value ZW.

10. The device (1) according to claim 7 or 8, **characterized in that** the control device (13) is configured in the special operating mode for refilling liquid helium to change the setpoint value SW non-linearly over time, wherein a helium flow through the control valve (5) is kept approximately constant during the duration of the transition of the setpoint value SW to the target value ZW.

11. The device (1) according to claim 10, **characterized in that** the control device (13) is configured in the special operating mode for refilling liquid helium to lower the setpoint value SW more quickly at the beginning of the transition than towards the end of the transition when transitioning the setpoint value SW to the target value ZW.

12. The device (1) according to any of the preceding claims, **characterized in that**
the device (1) further comprises an alarm device (15) with which an alarm message is automatically triggered (600) in one or more predetermined alarm situations,
in particular wherein the alarm device (15) comprises an acoustic signal generator (16) and/or an optical signal generator (16) and/or a radio signal generator and/or a data signal generator.

13. The device (1) according to claim 12 and according to any of claims 2 or 4, **characterized in that** an alarm situation comprises that the pressure value D1 of the helium tank pressure (2) falls below the pressure value D2 of the atmospheric pressure.

14. The device (1) according to claim 12 or 13, **characterized in that** an alarm situation comprises that the pressure value D1 of the helium tank pressure exceeds a predetermined helium tank pressure maximum value,
in particular wherein a first alarm situation for D1 comprises that the pressure value D1 of the helium tank pressure exceeds a predetermined first helium tank pressure maximum value EHM, a second alarm situation for D1 comprises that the pressure value D1 of the helium tank pressure exceeds a predetermined second helium tank pressure maximum value ZHM, and ZHM>EHM, and the alarm messages for the first alarm situation for D1 and the second alarm situation for D1 are different.

15. The device (1) according to any of claims 12 to 14 and according to claim 5, **characterized in that** an alarm situation comprises that a measured helium flow value exceeds a predetermined maximum helium flow value.

16. The device (1) according to claim 15, **characterized in that** the predetermined maximum helium flow value depends on changes in the helium tank pressure that are currently or recently controlled,
in particular wherein the maximum helium flow value is higher during and/or shortly after reductions made in the helium tank pressure than when the helium tank pressure is controlled to be constant.

17. The device (1) according to any of claims 12 to 16 and according to claim 5, **characterized in that** an alarm situation comprises that a measured helium flow value falls below a predetermined minimum helium flow value.

18. The device (1) according to claim 17, **characterized in that** the predetermined minimum helium flow value depends on current or recently controlled changes in the helium tank pressure,
in particular wherein the minimum helium flow value during and/or shortly after increases made in the helium tank pressure is lower than when the helium tank pressure is controlled to be constant.

19. The device (1) according to any of claims 12 to 18 and according to claim 5, **characterized in that** an alarm situation comprises that a measured helium flow value is zero and at the same time a current position of the control valve (5) or a position of the control valve (5) currently controlled by the control device (13) is not closed.

20. The device (1) according to any of claims 12 to 19 and according to claim 5 and according to any of claims 3 or 4, **characterized in that** an alarm situation comprises that a measured helium flow value is zero and at the same time a pressure value D2 in the helium recovery system (4) has risen to the pressure value D1 in the helium tank (2).

21. The device (1) according to any of claims 12 to 20 and according to claim 4, **characterized in that** an alarm situation comprises that a difference DHA=DHR-DAT of a measured pressure value DHR in the helium recovery system (4) and a measured pressure value DAT in the ambient atmosphere (atm) exceeds a predetermined threshold value SWW, in particular wherein SWW is selected in a range from 2.5 mbar to 20 mbar.

22. The device (1) according to any of claims 12 to 21, **characterized in that** at least some of the alarm situations take into account a current position of the control valve (5) or a position of the control valve (5) currently controlled by the control device (13).

23. A method for regulating the pressure in a helium tank (2) of an NMR magnet (23),
wherein a first pressure in the helium tank (2) is measured by a first pressure sensor (6),
wherein a control valve (5) is used to adjust an outflowing helium gas flow from the helium tank (2),
wherein an electronic control device (13) controls the control valve (5),
wherein a second pressure outside the helium tank (2) is measured with at least one second pressure sensor (7; 7a),
wherein the electronic control device (13)
- obtains the first pressure values D1 measured by the first pressure sensor (6),
- and adjusts a position of the control valve (5) depending on the measured first pressure values D1, so that the first pressure values D1 are adjusted to a predetermined setpoint value SW,
- and obtains second pressure values D2 measured by the second pressure sensor (7; 7a),
and wherein the control device (13) in a normal operating mode for NMR measurements further
- determines the setpoint value SW in dependence on the measured first pressure values D1 and second pressure values D2,
- namely changes the setpoint value SW for the pressure in the helium tank (2) in steps as soon as a difference DIF=D1-D2 between the measured first pressure value D1 and the measured second pressure value D2 reaches or exceeds predetermined threshold values,
wherein the setpoint value SW is raised by one step when the difference DIF becomes less than or equal to an increase threshold value HSW, and the setpoint value SW is lowered by one step when the difference DIF becomes greater than or equal to a decrease threshold value SSW, with HSW<SSW, and wherein a respective step by which the setpoint value SW is changed as soon as the difference DIF=D1-D2 between the measured first pressure value D1 and the measured second pressure value D2 reaches or exceeds the predetermined threshold values is selected in the range 5-25 mbar,
in particular wherein the method is carried out using a device (1) according to any of the preceding claims.

24. The method according to claim 23, **characterized in that** in a special operating mode for refilling liquid helium the control device (13) transitions the setpoint value SW for the pressure in the helium tank (2) to a target value ZW over a predetermined period of time, wherein the target value ZW is dependent on the second pressure value D2,
in particular wherein the period of time can be selected by a user,
in particular wherein the method is carried out using a device (1) according to claim 9.

25. The method according to claim 24, **characterized in that**
in the special operating mode for refilling liquid helium the control device (13) changes the setpoint value SW non-linearly over time, wherein a helium flow through the control valve (5) is kept approximately constant during the duration of the transfer of the setpoint value SW to the target value ZW,
in particular wherein the method is carried out using a device (1) according to claim 10.

26. The method according to any of claims 23 to 25,
**characterized in that** an alarm message is automatically triggered (600) by an alarm device (15) in any or more predetermined alarm situations,
in particular wherein the alarm device (15) comprises an acoustic signal generator (16) and/or an optical signal generator (16) and/or a radio signal generator and/or a data signal generator,
and that an alarm situation comprises that a measured helium flow value of the outflowing helium gas flow from the helium tank (2) through the control valve (59) is zero and at the same time a current position of the control valve (5) or a position of the control valve (5) currently controlled by the control device (13) is not closed,
in particular wherein the method is carried out using a device (1) according to claim 19.

27. A cryostat arrangement (21), comprising
- a vacuum-insulated helium tank (2),
- a device (1) according to any of claims 1 to 22,
wherein the first pressure sensor (6) is connected to the helium tank (2) and the second pressure sensor (7; 7a) is connected to a location outside the helium tank (2),
in particular wherein the second pressure sensor (7; 7a) is connected to the surrounding atmosphere (atm) or to a helium recovery system (4),
and wherein the control valve (5) is arranged in a helium line (3) leading away from the helium tank (2).

28. The cryostat arrangement (21) according to claim 27, **characterized in that** the cryostat arrangement (21) further comprises a helium recovery system (4) which is connected to the outgoing helium line (3).

29. An NMR measuring arrangement (20), comprising
- a cryostat arrangement (21) according to any of claims 27 or 28,
- a superconducting NMR magnet (23) in the helium tank (2) of the cryostat arrangement (21),
- an NMR probe head (31) which projects into a room-temperature bore (22a) of the vacuum-insulated helium tank (2), and
- an NMR spectrometer control device (32) for controlling NMR measurements with the NMR probe head (31).

30. A use of an NMR measuring arrangement (20) according to claim 29 for carrying out NMR measurements,
wherein the electronic control device (13) communicates a status of the regulation of the helium tank pressure to the NMR spectrometer control device (32),
and wherein during times of pressure instability in the helium tank (2), the NMR spectrometer control device (32) pauses the NMR measurements.

## Revendications

1. Dispositif (1) de régulation de la pression au sein d'un réservoir d'hélium (2) d'un aimant RMN (23), comprenant :
- un premier capteur de pression (6) permettant de mesurer une première pression au sein du réservoir d'hélium (2),
- au moins un deuxième capteur de pression (7 ; 7a) permettant de mesurer une deuxième pression à l'extérieur du réservoir d'hélium (2),
- une vanne d'ajustement (5) permettant de régler un débit d'hélium gazeux sortant du réservoir d'hélium (2),
- un dispositif de régulation électronique (13) permettant de commander la vanne d'ajustement (5),
le dispositif de régulation électronique (13) étant conçu pour
- recevoir des premières valeurs de pression D1 mesurées par le premier capteur de pression (6),
- et ajuster une position de la vanne d'ajustement (5) en fonction des premières valeurs de pression D1 mesurées, les premières valeurs de pression D1 étant régulées à une valeur de consigne SW prédéfinie,
- recevoir des deuxièmes valeurs de pression D2 mesurées par le deuxième capteur de pression (7 ; 7a),
et le dispositif de régulation électronique (13) étant en outre conçu pour, dans le cas d'un fonctionnement normal des mesures RMN,
- déterminer la valeur de consigne SW en fonction des premières valeurs de pression D1 et des deuxièmes valeurs de pression D2,
- à savoir modifier progressivement la valeur de consigne SW de la pression au sein du réservoir d'hélium (2) dès qu'une différence DIF=D1-D2 entre la première valeur de pression D1 mesurée et la deuxième valeur de pression D2 mesurée atteint ou dépasse des valeurs de seuil prédéfinies,
la valeur de consigne SW étant augmentée d'un niveau lorsque la différence DIF devient inférieure ou égale à une valeur de seuil de hausse HSW, et la valeur de consigne SW étant abaissée d'un niveau lorsque la différence DIF devient supérieure ou égale à une valeur de seuil de baisse SSW, avec HSW<SSW,
et un niveau respectif, avec lequel la valeur de consigne SW est modifiée dès que la différence DIF=D1-D2 entre la première valeur de pression D1 mesurée et la deuxième valeur de pression D2 mesurée atteint ou dépasse les valeurs de seuil prédéfinies, est sélectionné dans la plage comprise entre 5 et 25 mbar.

2. Dispositif (1) selon la revendication 1, **caractérisé en ce que** la deuxième pression est une pression de l'atmosphère environnante (atm).

3. Dispositif (1) selon la revendication 1, **caractérisé en ce que** la deuxième pression est une pression au sein d'un système de récupération d'hélium (4).

4. Dispositif de mesure selon la revendication 1, **caractérisé en ce que** le dispositif (1) comprend en outre
- un troisième capteur de pression (9) permettant de mesurer une troisième pression à l'extérieur du réservoir d'hélium (2),
la deuxième pression et la troisième pression comprenant une pression de l'atmosphère environnante (atm) et une pression au sein d'un système de récupération d'hélium (4).

5. Dispositif (1) selon l'une quelconque des revendications précédentes, **caractérisé en ce que** le dispositif (1) comprend en outre
- un capteur de débit (14) permettant de mesurer une valeur de débit d'hélium du flux d'hélium gazeux sortant du réservoir d'hélium (2).

6. Dispositif (1) selon l'une quelconque des revendications précédentes, **caractérisé en ce que** le dispositif de régulation (13) comprend un dispositif de mémoire (17) ou une connexion pour un dispositif de mémoire (17), avec lequel ou laquelle des valeurs de capteur reçues par le dispositif de régulation (13) sont enregistrées.

7. Dispositif de mesure (1) selon l'une quelconque des revendications précédentes, **caractérisé en ce que** :
le dispositif de régulation (13) est conçu pour, dans un mode de fonctionnement spécial de remplissage d'hélium liquide
- reporter la valeur de consigne SW pour la pression au sein du réservoir d'hélium (2) sur une valeur cible ZW pendant une durée prédéfinie, la valeur cible ZW étant fonction de la deuxième valeur de pression D2,
la durée pouvant en particulier être sélectionnée par un utilisateur.

8. Dispositif (1) selon la revendication 7, **caractérisé en ce que** la valeur cible ZW correspond à la deuxième valeur de pression D2 avec ZW=D2, ou la valeur cible ZW est supérieure à la deuxième valeur de pression D2 à raison d'un petit supplément de pression DA, avec ZW=D2+DA et avec DA≤3 mbar.

9. Dispositif (1) selon la revendication 7 ou 8, **caractérisé en ce que** le dispositif de régulation (13) est conçu pour, dans le mode de fonctionnement spécial de remplissage d'hélium liquide, reporter la valeur de consigne SW sur la valeur cible ZW de manière linéaire dans le temps.

10. Dispositif (1) selon la revendication 7 ou 8, **caractérisé en ce que**, dans le mode de fonctionnement spécial de remplissage d'hélium liquide, le dispositif de régulation (13) est conçu pour modifier la valeur de consigne SW de manière non linéaire dans le temps, un débit d'hélium à travers la vanne d'ajustement (5) étant maintenu approximativement constant pendant la durée du report de la valeur de consigne SW sur la valeur cible ZW.

11. Dispositif (1) selon la revendication 10, **caractérisé en ce que** le dispositif de régulation (13) est conçu pour, dans le mode de fonctionnement spécial de remplissage d'hélium liquide et lors du report de la valeur de consigne SW sur la valeur cible ZW, abaisser la valeur de consigne SW plus rapidement au début du report qu'à la fin du report.

12. Dispositif de mesure (1) selon l'une quelconque des revendications précédentes, **caractérisé en ce que** :
le dispositif (1) comprend en outre un dispositif d'alarme (15) avec lequel un message d'alarme est déclenché automatiquement (600) dans une ou plusieurs situation(s) d'alarme prédéfinie(s),
le dispositif d'alarme (15) comprenant en particulier un générateur de signal acoustique (16) et/ou un générateur de signal optique (16) et/ou un générateur de signal radio et/ou un générateur de signal de données.

13. Dispositif (1) selon la revendication 12 et selon l'une quelconque des revendications 2 ou 4, **caractérisé en ce qu'**une situation d'alarme comprend le cas où la valeur de pression D1 de la pression de réservoir d'hélium (2) descend en dessous de la valeur de pression D2 de la pression atmosphérique.

14. Dispositif (1) selon la revendication 12 ou 13, **caractérisé en ce qu'**une situation d'alarme comprend le cas où la valeur de pression D1 de la pression de réservoir d'hélium dépasse une valeur maximale prédéfinie de pression de réservoir d'hélium, une première situation d'alarme par rapport à D1 comprenant en particulier le cas où la valeur de pression D1 de la pression de réservoir d'hélium dépasse une première valeur maximale prédéfinie de pression de réservoir d'hélium EHM, une deuxième situation d'alarme par rapport à D1 comprenant le cas où la valeur de pression D1 de la pression de réservoir d'hélium dépasse une deuxième valeur maximale prédéfinie de pression de réservoir d'hélium ZHM, et ZHM>EHM, et les messages d'alarme pour la première situation d'alarme par rapport à D1 et pour la deuxième situation d'alarme par rapport à D1 étant différents.

15. Dispositif (1) selon l'une quelconque des revendications 12 à 14 et selon la revendication 5, **caractérisé en ce qu'**une situation d'alarme comprend le cas où une valeur de débit d'hélium mesurée dépasse une valeur maximale prédéfinie de débit d'hélium.

16. Dispositif (1) selon la revendication 15, **caractérisé en ce que** la valeur maximale prédéfinie de débit d'hélium dépend de modifications de la pression de réservoir d'hélium immédiatement ou récemment commandées,
la valeur maximale de débit d'hélium étant en particulier plus élevée pendant, et/ou peu de temps après, la mise en œuvre d'abaissements de la pression de réservoir d'hélium que lorsque la pression de réservoir d'hélium est commandée de manière être constante.

17. Dispositif (1) selon l'une quelconque des revendications 12 à 16 et selon la revendication 5, **caractérisé en ce qu'**une situation d'alarme comprend le cas où une valeur de débit d'hélium mesurée dépasse une valeur minimale prédéfinie de débit d'hélium.

18. Dispositif (1) selon la revendication 17, **caractérisé en ce que** la valeur minimale prédéfinie de débit d'hélium dépend de modifications de la pression de réservoir d'hélium immédiatement ou récemment commandées,
la valeur minimale de débit d'hélium étant en particulier plus basse pendant, et/ou peu de temps après, la mise en œuvre d'augmentations de la pression de réservoir d'hélium que lorsque la pression de réservoir d'hélium est commandée de manière être constante.

19. Dispositif (1) selon l'une quelconque des revendications 12 à 18 et selon la revendication 5, **caractérisé en ce qu'**une situation d'alarme comprend le cas où une valeur de débit d'hélium mesurée est égale à zéro et où simultanément une présente position de la vanne d'ajustement (5) ou une position, présentement commandée par le dispositif de régulation (13), de la vanne d'ajustement (5) n'est pas une position de fermeture.

20. Dispositif (1) selon l'une quelconque des revendications 12 à 19 et selon la revendication 5 et selon l'une quelconque des revendications 3 ou 4, **caractérisé en ce qu'**une situation d'alarme comprend le cas où une valeur de débit d'hélium mesurée est égale à zéro et où simultanément une valeur de pression D2 au sein du système de récupération d'hélium (4) a augmenté jusqu'à la valeur de pression D1 au sein du réservoir d'hélium (2).

21. Dispositif (1) selon l'une quelconque des revendications 12 à 20 et selon la revendication 4, **caractérisé en ce qu'**une situation d'alarme comprend le cas où une différence DHA= DHR-DAT entre une valeur de pression mesurée DHR au sein du système de récupération d'hélium (4) et une valeur de pression mesurée DAT de l'atmosphère environnante (atm) dépasse une valeur de seuil SWW prédéfinie, SWW étant en particulier sélectionnée dans une plage comprise entre 2,5 mbar et 20 mbar.

22. Dispositif (1) selon l'une quelconque des revendications 12 à 21, **caractérisé en ce qu'**au moins une partie des situations d'alarme incluent une position présente de la vanne d'ajustement (5) ou une position, présentement commandée par le dispositif de régulation (13), de la vanne d'ajustement (5).

23. Procédé de régulation de la pression au sein d'un réservoir d'hélium (2) d'un aimant RMN (23), dans lequel
une première pression est mesurée au sein du réservoir d'hélium (2) à l'aide d'un premier capteur de pression (6),
un débit d'hélium gazeux sortant du réservoir d'hélium (2) est ajusté à l'aide d'une vanne d'ajustement (5),
un dispositif de régulation électronique (13) commande la vanne d'ajustement (5), une deuxième pression à l'extérieur du réservoir d'hélium (2) est mesurée à l'aide du au moins un deuxième capteur de pression (7 ; 7a),
le dispositif de régulation électronique (13)
- reçoit des premières valeurs de pression D1 mesurées par le premier capteur de pression (6),
- et ajuste une position de la vanne d'ajustement (5) en fonction des premières valeurs de pression D1 mesurées, de sorte que les premières valeurs de pression D1 sont régulées à une valeur de consigne SW prédéfinie,
- et reçoit des deuxièmes valeurs de pression D2 mesurées par le deuxième capteur de pression (7 ; 7a),
et le dispositif de régulation électronique (13), dans un mode de fonctionnement normal des mesures RMN,
- détermine en outre la valeur de consigne SW en fonction des premières valeurs de pression D1 mesurées et des deuxièmes valeurs de pression D2 mesurées,
- à savoir modifie progressivement la valeur de consigne SW de la pression au sein du réservoir d'hélium (2) dès qu'une différence DIF=D1-D2 entre la première valeur de pression D1 mesurée et la deuxième valeur de pression D2 mesurée atteint ou dépasse des valeurs de seuil prédéfinies,
la valeur de consigne SW étant augmentée d'un niveau lorsque la différence DIF devient inférieure ou égale à une valeur de seuil de hausse HSW, et la valeur de consigne étant abaissée d'un niveau lorsque la différence DIF devient supérieure ou égale à une valeur de seuil de baisse SSW, avec HSW<SSW, et un niveau respectif, avec lequel la valeur de consigne SW est modifiée dès que la différence DIF=D1-D2 entre la première valeur de pression D1 mesurée et la deuxième valeur de pression D2 mesurée atteint ou dépasse les valeurs de seuil prédéfinies, est sélectionné dans la plage comprise entre 5 et 25 mbar,
le procédé étant en particulier mis en œuvre à l'aide d'un dispositif (1) selon l'une quelconque des revendications précédentes.

24. Procédé selon la revendication 23, **caractérisé en ce que**,
dans un mode de fonctionnement spécial de remplissage d'hélium liquide, le dispositif de régulation (13) reporte la valeur de consigne SW pour la pression au sein du réservoir d'hélium (2) sur une valeur cible ZW pendant une durée prédéfinie, la valeur cible ZW étant fonction de la deuxième valeur de pression D2,
la durée pouvant en particulier être sélectionnée par un utilisateur.
le procédé étant en particulier mis en œuvre à l'aide d'un dispositif (1) selon la revendication 9.

25. Dispositif (1) selon la revendication 7 ou 24, **caractérisé en ce que**,
dans le mode de fonctionnement spécial de remplissage d'hélium liquide, le dispositif de régulation (13) modifie la valeur de consigne SW de manière non linéaire dans le temps, un débit d'hélium à travers la vanne d'ajustement (5) étant maintenu approximativement constant pendant la durée du report de la valeur de consigne SW sur la valeur cible ZW,
le procédé étant en particulier mis en œuvre à l'aide d'un dispositif (1) selon la revendication 10.

26. Procédé selon l'une quelconque des revendications 23 à 25, **caractérisé en ce qu'**un message d'alarme est déclenché automatiquement (600) par un dispositif d'alarme (15) dans une ou plusieurs situation(s) d'alarme prédéfinie(s),
le dispositif d'alarme (15) comprenant en particulier un générateur de signal acoustique (16) et/ou un générateur de signal optique (16) et/ou un générateur de signal radio et/ou un générateur de signal de données,
et une situation d'alarme comprend le cas où une valeur de débit d'hélium mesurée du débit d'hélium gazeux sortant du réservoir d'hélium (2) à travers la vanne d'ajustement (5) est nulle et où simultanément une position présente de la vanne d'ajustement (5) ou une position, présentement commandée par le dispositif de régulation (13), de la vanne d'ajustement (5) n'est pas une position de fermeture,
le procédé étant en particulier mis en œuvre à l'aide d'un dispositif (1) selon la revendication 19.

27. Dispositif cryostatique (21) comprenant
- un réservoir d'hélium (2) isolé sous vide,
- un dispositif (1) selon l'une quelconque des revendications 1 à 22,
le premier capteur de pression (6) étant relié au réservoir d'hélium (2) et le deuxième capteur de pression (7 ; 7a) étant relié à un endroit situé à l'extérieur du réservoir d'hélium (2),
le deuxième capteur de pression (7 ; 7a) étant en particulier relié à l'atmosphère environnante (atm) ou à un système de récupération d'hélium (4),
et la vanne d'ajustement (5) étant agencée dans une conduite d'hélium (3) partant du réservoir d'hélium (2).

28. Dispositif cryostatique (21) selon la revendication 27, **caractérisé en ce que** le dispositif cryostatique (21) comprend en outre un système de récupération d'hélium (4) qui est raccordé à la conduite d'hélium (3) sortante.

29. Dispositif de mesure RMN (20), comprenant
- un dispositif cryostatique (21) selon l'une quelconque des revendications 27 ou 28,
- un aimant RMN supraconducteur (23) au sein du réservoir d'hélium (2) du dispositif cryostatique (21),
- une tête d'échantillonnage RMN (31) qui pénètre dans un alésage de température ambiante (22a) du réservoir d'hélium (2) isolé sous vide, et
- un dispositif de commande de spectromètre RMN (32) permettant de commander des mesures RMN avec la tête d'échantillonnage RMN (31).

30. Utilisation d'un dispositif de mesure RMN (20) selon la revendication 29 afin de mettre en œuvre des mesures RMN,
le dispositif de régulation électronique (13) communiquant un statut de la régulation de la pression de réservoir d'hélium au dispositif de commande de spectromètre RMN (32),
et le dispositif de commande de spectromètre RMN (32) mettant en pause les mesures RMN pendant les périodes d'instabilité de pression au sein du réservoir d'hélium (2).
